# EUROPEAN PATENT APPLICATION

(11) **EP 4 776 796 A1**
(43) Date of publication of application: **15.07.2026**
(21) Application number: 26150741.2
(22) Date of filing: 08.01.2026
(51) Int. Cl.: H10F 39/12, H10F 39/00

(54) **PHOTOELECTRIC CONVERSION ELEMENT, PHOTOELECTRIC CONVERSION DEVICE, AND EQUIPMENT**

(30) Priority: 10.01.2025 JP 2025003984
(71) Applicant: Canon Kabushiki Kaisha, Tokyo, 146-8501 (JP)
(72) Inventor: SHINOHARA, Mahito, Ohta-ku, Tokyo, 146-8501 (JP)
(74) Representative: TBK

(57) **Abstract**

A photoelectric conversion element (22), provided in a semiconductor layer (120) having a first face (122) and a second face (124), includes a first semiconductor region (126) of a first conductivity type arranged over a first depth (D3) from the first face, a second semiconductor region (136) of a second conductivity type arranged to surround the first semiconductor region in a plan view and having a peak of an impurity concentration at a second depth between the first face and the first depth, and a third semiconductor region (128) of the second conductivity type arranged closer to the second face than the first semiconductor region to the second face and configuring an avalanche photodiode with the first semiconductor region. A boundary face of the second semiconductor region on a side of the second face is located closer to the first face than the first depth to the first face.

## Description

### TECHNICAL FIELD

The present disclosure relates to a photoelectric conversion element, a photoelectric conversion device, and an equipment.

### BACKGROUND

A single photon avalanche diode (SPAD) is known as a detector capable of detecting weak light at a single photon level. The SPAD uses an avalanche multiplication phenomenon generated by a strong electric field induced in a p-n junction of a semiconductor to multiply a signal charge excited by a photon to about several times to several million times. By converting the current generated by the avalanche multiplication phenomenon into a pulse signal and counting the number of pulse signals, it is possible to directly measure the number of incident photons. Japanese Patent Laid-Open No. 2020-057651 describes a photodetection device and a photodetection system using SPADs.

### SUMMARY

Japanese Patent Laid-Open No. 2020-057651 discloses a configuration in which a semiconductor region having a low impurity concentration is arranged between a cathode and an anode to increase the electric field strength between the cathode and the anode from the viewpoint of reducing noise while suppressing an increase in operating voltage. However, in the configuration described in Japanese Patent Laid-Open No. 2020-057651, although an increase in the operating voltage may be suppressed by increasing the electric field strength between the cathode and the anode, noise due to carriers generated at carrier generation level in the photoelectric conversion element may be generated.

The present disclosure is directed to provide a photoelectric conversion element and a photoelectric conversion device capable of reducing noise caused by carriers generated from carrier generation level in the photoelectric conversion element.

The present disclosure in its first aspect provides a photoelectric conversion element as specified in claim 1. Optional features are specified in claims 2 to 17.

The present disclosure in its second aspect provides a photoelectric conversion device as specified in claim 18. Optional features are specified in claim 19.

The present disclosure in its third aspect provides an equipment as specified in claim 20.

According to the present disclosure, it is possible to reduce noise caused by carriers generated from carrier generation levels in a photoelectric conversion element.

Features of the present disclosure will become apparent from the following description of embodiments with reference to the attached drawings. The following description of embodiments is described by way of example.

### BRIEF DESCRIPTION OF THE DRAWINGS

Fig. 1 and Fig. 2 are block diagrams illustrating a schematic configuration of a photoelectric conversion device according to a first embodiment.
Fig. 3 is a block diagram illustrating a configuration example of a pixel of the photoelectric conversion device according to the first embodiment.
Fig. 4A, Fig. 4B, Fig. 4C, Fig. 5A, Fig. 5B, Fig. 5C, and Fig. 5D are diagrams illustrating the basic operation of the photoelectric conversion unit in the photoelectric conversion device according to the first embodiment.
Fig. 6 is a perspective view illustrating a configuration example of the photoelectric conversion device according to the first embodiment.
Fig. 7 is a schematic cross-sectional view illustrating a structure of the photoelectric conversion device according to the first embodiment.
Fig. 8 is a plan view illustrating the structure of the photoelectric conversion element of the photoelectric conversion device according to the first embodiment.
Fig. 9 is a schematic cross-sectional view illustrating a structure of the photoelectric conversion element of the photoelectric conversion device according to the first embodiment.
Fig. 10 is a graph illustrating a depth distribution of impurities constituting the photoelectric conversion element of the photoelectric conversion device according to the first embodiment.
Fig. 11 is a schematic cross-sectional view illustrating a structure of a photoelectric conversion element of a photoelectric conversion device according to a reference example.
Fig. 12 is a schematic cross-sectional view illustrating a structure of a photoelectric conversion element of a photoelectric conversion device according to a second embodiment.
Fig. 13 is a graph illustrating a depth distribution of impurities constituting the photoelectric conversion element of the photoelectric conversion device according to the second embodiment.
Fig. 14 is a schematic cross-sectional view illustrating a structure of a photoelectric conversion element in a photoelectric conversion device according to a modification of the second embodiment.
Fig. 15 is a block diagram illustrating a schematic configuration of a photodetection system according to a third embodiment.
Fig. 16 is a block diagram illustrating a schematic configuration of a range image sensor according to a fourth embodiment.
Fig. 17 is a schematic diagram illustrating a configuration example of an endoscopic surgical system according to a fifth embodiment.
Fig. 18A, Fig. 18B, and Fig. 18C are schematic diagrams illustrating a configuration example of a movable object according to a sixth embodiment.
Fig. 19 is a block diagram illustrating a schematic configuration of a photodetection system according to the sixth embodiment.
Fig. 20 is a flowchart illustrating an operation of the photodetection system according to the sixth embodiment.
Fig. 21A and Fig. 21B are schematic diagrams illustrating a schematic configuration of a photodetection system according to a seventh embodiment.
Fig. 22 is a block diagram illustrating a schematic configuration of an equipment according to an eighth embodiment.

### DESCRIPTION OF THE EMBODIMENTS

Hereinafter, embodiments of the present disclosure will be described in detail with reference to the accompanying drawings. Note that the following embodiments do not limit the technology according to the claims. Although multiple features are described in the embodiments, not all of these multiple features are essential to the present disclosure, and multiple features may be arbitrarily combined. In the following description, a term indicating a specific direction or position (for example, "up", "down", "right", "left" and other terms including those terms) is used as necessary. The use of these terms is to facilitate understanding of the embodiments with reference to the drawings, and the technical scope of the present disclosure is not limited by the meanings of these terms. In addition, sizes and positional relationships of members illustrated in the drawings may be exaggerated for clarity of description.

In each of the embodiments described below, a photoelectric conversion device for imaging purposes will be mainly described as an example of a semiconductor device. However, the embodiments are not limited to photoelectric conversion devices for imaging purposes and may be applied to other semiconductor devices. For example, other examples of the semiconductor device include a ranging device (a device for distance measurement and the like using a focus detection or a time of flight (TOF)), a photometric device (a device for measuring the amount of incident light), and the like.

### First Embodiment

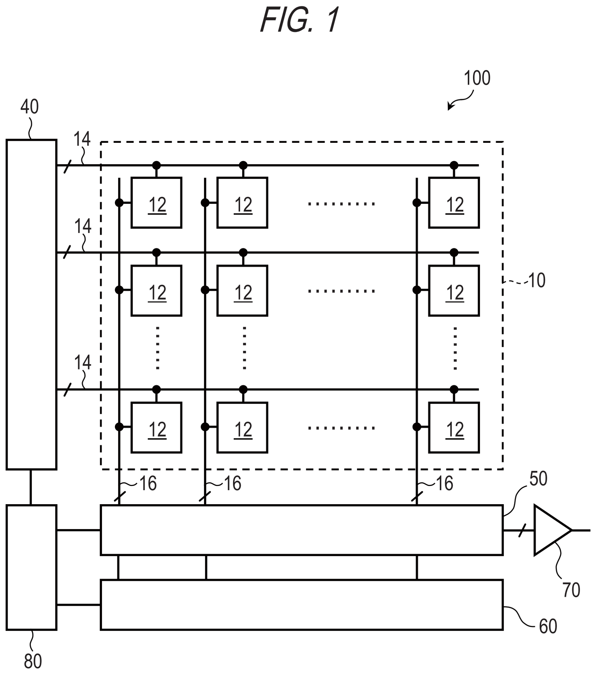

A schematic configuration of a photoelectric conversion device according to a first embodiment will be described with reference to Fig. 1. Fig. 1 is a block diagram illustrating a schematic configuration of a photoelectric conversion device according to the present embodiment.

As illustrated in Fig. 1, the photoelectric conversion device 100 according to the present embodiment includes a pixel region 10, a vertical scanning circuit unit 40, a readout circuit unit 50, a horizontal scanning circuit unit 60, an output circuit unit 70, and a control pulse generation unit 80.

The pixel region 10 is provided with a plurality of pixels 12 arranged in an array so as to form a plurality of rows and a plurality of columns. As described later, each pixel 12 may include a photoelectric conversion unit including a photoelectric conversion element and a signal processing unit that processes a signal output from the photoelectric conversion unit. The number of pixels 12 constituting the pixel region 10 is not particularly limited. For example, like a general digital camera, the pixel region 10 may include a plurality of pixels 12 arranged in an array of several thousand rows × several thousand columns. Alternatively, the pixel region 10 may include a plurality of pixels 12 arranged in one row or one column. Alternatively, the pixel region 10 may include one pixel 12.

In each row of the pixel array of the pixel region 10, a control line 14 is arranged so as to extend in a first direction (lateral direction in Fig. 1). Each of the control lines 14 is connected to the pixels 12 arranged in the first direction on the corresponding row, respectively, and forms a signal line common to these pixels 12. The first direction in which the control lines 14 extend may be referred to as a row direction or a horizontal direction. Each of the control lines 14 may include a plurality of signal lines for supplying a plurality of types of control signals to the pixels 12.

In each column of the pixel array of the pixel region 10, an output line 16 is arranged so as to extend in a second direction (vertical direction in Fig. 1) intersecting the first direction. Each of the output lines 16 is connected to the pixels 12 arranged in the second direction on the corresponding column, respectively, and forms a signal line common to these pixels 12. The second direction in which the output line 16 extends may be referred to as a column direction or a vertical direction. Each of the output lines 16 may include a plurality of signal lines. For example, each of the output lines 16 may include a plurality of signal lines for transferring a digital signal of a plurality of bits output from the pixel 12 on a bit-by-bit basis.

The control lines 14 of the respective rows are connected to the vertical scanning circuit unit 40. The vertical scanning circuit unit 40 is a control circuit having a function of generating a control signal for driving the pixels 12 in response to a control signal from the control pulse generation unit 80 and supplying the generated control signal to the pixels 12 via the control line 14. A logic circuit such as a shift register or an address decoder may be used as the vertical scanning circuit unit 40. The vertical scanning circuit unit 40 sequentially scans the pixels 12 in the pixel region 10 row by row to output the pixel signals of the pixels 12 to the readout circuit unit 50 via the output lines 16.

The output lines 16 of the respective columns are connected to the readout circuit unit 50. The readout circuit unit 50 includes a plurality of holding units (not illustrated) provided corresponding to each column of the pixel array of the pixel region 10 and has a function of holding the pixel signals of the pixels 12 of the respective columns output from the pixel region 10 in units of rows via the output lines 16 in the holding units of the corresponding columns.

The horizontal scanning circuit unit 60 is a control circuit having a function of generating a control signal for reading out the pixel signal from the holding unit of each column of the readout circuit unit 50 in response to a control signal from the control pulse generation unit 80 and supplying the generated control signal to the readout circuit unit 50. A logic circuit such as a shift register or an address decoder may be used as the horizontal scanning circuit unit 60. The horizontal scanning circuit unit 60 sequentially scans the holding units of the respective columns of the readout circuit unit 50 to sequentially output the pixel signals held in the holding units to the output circuit unit 70.

The output circuit unit 70 is a circuit unit for outputting the pixel signal output from the readout circuit unit 50 to the outside of the photoelectric conversion device 100 and includes an external interface circuit. The external interface circuit included in the output circuit unit 70 is not particularly limited. As the external interface circuit, for example, a serializer/deserializer (SerDes) transmission circuit may be applied. Examples of the SerDes transmission circuit include a low voltage differential signaling (LVDS) circuit and a scalable low voltage signaling (SLVS) circuit. Note that the output circuit unit 70 may further include a signal processing circuit that performs predetermined digital signal processing on the pixel signal output from the readout circuit unit 50 provided before the external interface circuit.

The control pulse generation unit 80 is a control circuit for generating control signals for controlling the operations and timings thereof of the vertical scanning circuit unit 40, the readout circuit unit 50, and the horizontal scanning circuit unit 60, and supplying the generated control signals to the respective functional blocks. At least a part of the control signals for controlling the operations and timings thereof of the vertical scanning circuit unit 40, the readout circuit unit 50, and the horizontal scanning circuit unit 60 may be supplied from the outside of the photoelectric conversion device 100.

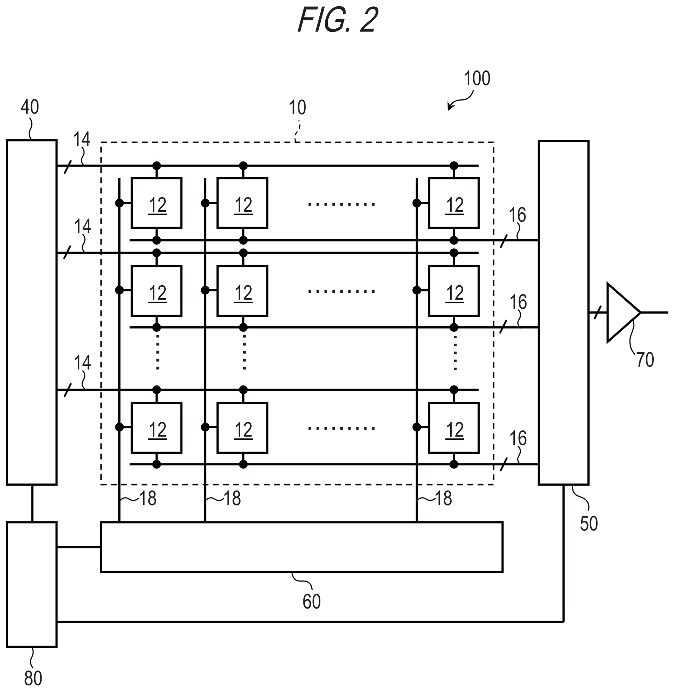

The connection mode of each functional block of the photoelectric conversion device 100 is not limited to the configuration example of Fig. 1 and may be configured as illustrated in Fig. 2, for example.

In the configuration example of Fig. 2, the output line 16 extending in the first direction is arranged in each row of the pixel array of the pixel region 10. Each of the output lines 16 is connected to the pixels 12 arranged in the first direction on the corresponding row, respectively, and forms a signal line common to these pixels 12. A control line 18 extending in the second direction is arranged in each column of the pixel array of the pixel region 10. Each of the control lines 18 is connected to the pixels 12 arranged in the second direction on the corresponding column, respectively, and forms a signal line common to these pixels 12.

The control line 18 of each column is connected to the horizontal scanning circuit unit 60. The horizontal scanning circuit unit 60 generates a control signal for reading out the pixel signal from the pixel 12 in response to a control signal output from the control pulse generation unit 80 and supplies the generated control signal to the pixel 12 via the control line 18. Specifically, the horizontal scanning circuit unit 60 sequentially scans the plurality of pixels 12 in the pixel region 10 in units of columns to output the pixel signals of the pixels 12 in each row belonging to the selected column to the output lines 16.

The output line 16 of each row is connected to the readout circuit unit 50. The readout circuit unit 50 includes a plurality of holding units (not illustrated) provided corresponding to the respective rows of the pixel array of the pixel region 10 and has a function of holding the pixel signals of the pixels 12 of the respective rows output from the pixel region 10 in units of columns via the output lines 16 in the holding units of the corresponding rows.

The readout circuit unit 50 sequentially outputs the pixel signals held in the holding units of the respective rows to the output circuit unit 70 in response to a control signal output from the control pulse generation unit 80.

Other configurations in the configuration example of Fig. 2 may be the same as those in the configuration example of Fig. 1.

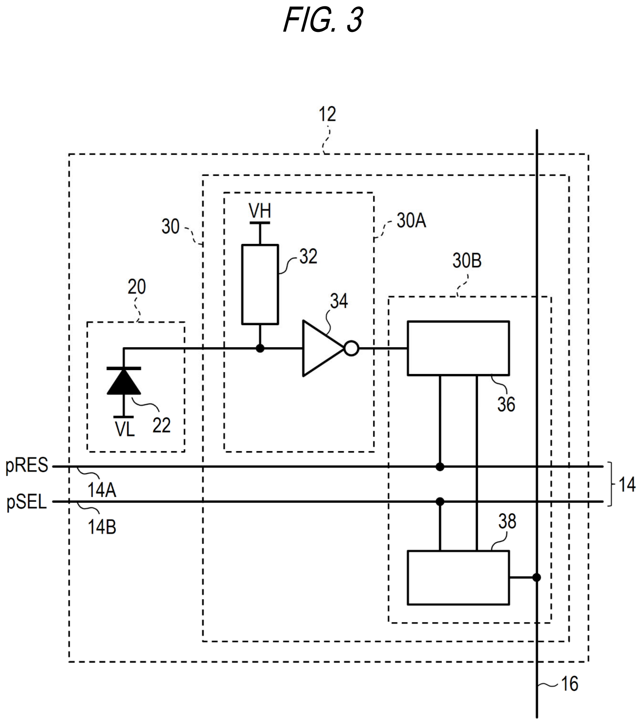

Fig. 3 is a block diagram illustrating a configuration example of the pixel 12. As illustrated in Fig. 3, each pixel 12 includes a photoelectric conversion unit 20 and a signal processing unit 30. The photoelectric conversion unit 20 includes a photoelectric conversion element 22 and outputs a signal according to incident light. The signal processing unit 30 is a signal processing circuit that processes a signal output from the photoelectric conversion unit 20. The signal processing unit 30 may include, for example, a functional block 30A including a quenching element 32 and a waveform shaping circuit 34, and a functional block 30B including a processing circuit 36 and a selection circuit 38. In the case of the pixel configuration illustrated in Fig. 3, the control line 14 of each row may include a signal line 14A to which a control signal pRES is supplied from the vertical scanning circuit unit 40 and a signal line 14B to which a control signal pSEL is supplied from the vertical scanning circuit unit 40.

The photoelectric conversion element 22 may be an avalanche photodiode (hereinafter referred to as "APD"). An anode of the APD constituting the photoelectric conversion element 22 is connected to a node to which a voltage VL is supplied. A cathode of the APD constituting the photoelectric conversion element 22 is connected to one terminal of the quenching element 32 and an input node of the waveform shaping circuit 34. A connection node of the photoelectric conversion element 22, the quenching element 32, and the waveform shaping circuit 34 is an output node of the photoelectric conversion unit 20 and is also an input node of the signal processing unit 30. The other terminal of the quenching element 32 is connected to a node to which a voltage VH higher than the voltage VL is supplied. The voltage VL and the voltage VH are set so that a reverse bias voltage sufficient for the APD to perform the avalanche multiplication operation is applied. In one example, a negative high voltage is applied as the voltage VL and a positive voltage comparable to a power supply voltage is applied as the voltage VH. For example, the voltage VL may be about -20 V to -30 V, and the voltage VH may be about 2 V to 3 V. In the following description, it is assumed that the voltage VL is -Vbd and the voltage VH is Vex for simplicity. Here, the voltage Vbd is a breakdown voltage of the APD, and the voltage Vex is an excess bias. That is, a voltage obtained by adding the excess bias Vex to the breakdown voltage Vbd is applied between the cathode and the anode of the APD.

The photoelectric conversion element 22 may be configured by an APD as described above. When a reverse bias voltage sufficient to perform the avalanche multiplication operation is supplied to the APD, carriers generated by light incident on the APD cause avalanche multiplication, and an avalanche current is generated. The operation modes in a state where the reverse bias voltage is supplied to the APD include a Geiger mode and a linear mode. The Geiger mode is an operation mode in which a voltage applied between the anode and the cathode is set to a reverse bias voltage larger than the breakdown voltage of the APD. The linear mode is an operation mode in which a voltage applied between the anode and the cathode is set to a reverse bias voltage close to or lower than the breakdown voltage of the APD. An APD that operates in Geiger mode is referred to as a single photon avalanche diode (SPAD). The APD constituting the photoelectric conversion element 22 may be operated in the linear mode or in the Geiger mode, but the SPAD having a larger potential difference than the APD in the linear mode and having a remarkable improvement effect of the signal-to-noise ratio is more preferable.

Although the anode of the APD is set to a fixed potential and a signal is extracted from the cathode side in the circuit configuration of Fig. 3, the cathode of the APD may be set to a fixed potential and a signal may be extracted from the anode side. In the former case, the signal charge is an electron. In the latter case, the signal charge is a hole. Further, in the present embodiment, a case where one node of the APD is set to a fixed potential will be described, but the potentials of both nodes may vary. In the following description, a configuration in which electrons are used as the signal charge will be described. When holes are used as the signal charge, the conductivity type of the semiconductor region constituting each part of the photoelectric conversion element 22 may be opposite to the conductivity type of the configuration described below.

The quenching element 32 has a function of converting a change in the avalanche current generated in the photoelectric conversion element 22 into a voltage signal. In addition, the quenching element 32 functions as a load circuit (quenching circuit) at the time of signal multiplication by avalanche multiplication and has a function of suppressing avalanche multiplication by reducing the voltage applied to the photoelectric conversion element 22. The operation in which the quenching element 32 suppresses avalanche multiplication is called a quenching operation. The quenching element 32 has a function of resetting the voltage supplied to the photoelectric conversion element 22 to the voltage VH by flowing a current corresponding to the voltage drop due to the quenching operation. The operation of resetting the voltage supplied from the quenching element 32 to the photoelectric conversion element 22 to the voltage VH is called a recharge operation. The quenching element 32 may be configured by a resistor, a MOS transistor, or the like.

The waveform shaping circuit 34 includes an input node to which the output signal of the photoelectric conversion unit 20 is supplied and an output node. The waveform shaping circuit 34 has a function of converting an analog signal supplied from the photoelectric conversion unit 20 into a pulse signal. The waveform shaping circuit 34 may be configured by a logic circuit including a NOT circuit (inverter circuit), a NOR circuit, a NAND circuit, and the like. The output node of the waveform shaping circuit 34 is connected to the processing circuit 36.

The processing circuit 36 includes an input node to which the output signal of the waveform shaping circuit 34 is supplied, a control node connected to the control line 14, and an output node. The processing circuit 36 has a function of performing predetermined signal processing on the output signal of the waveform shaping circuit 34 and holding the processed signal or the processing result. Although not particularly limited, the processing circuit 36 may include, for example, a counter circuit and a memory. When the processing circuit 36 includes a counter circuit, the processing circuit 36 counts pulses superimposed on a signal output from the waveform shaping circuit 34, and holds a count value which is a count result. The signal supplied from the vertical scanning circuit unit 40 to the processing circuit 36 via the control line 14 may include an enable signal for controlling a pulse counting period (exposure period), a reset signal for resetting a count value held by the processing circuit 36, and the like. Fig. 3 illustrates, as an example, a reset signal (control signal pRES) supplied via the signal line 14A. The output node of the processing circuit 36 is connected to the selection circuit 38.

The selection circuit 38 has a function of switching an electrical connection state (connection or non-connection) between the processing circuit 36 and the output line 16. The selection circuit 38 switches the connection state between the processing circuit 36 and the output line 16 according to a selection signal supplied from the vertical scanning circuit unit 40 via the control line 14 (or a selection signal supplied from the horizontal scanning circuit unit 60 via the control line 18 in the configuration example of Fig. 2). Fig. 3 illustrates, as an example, a selection signal (control signal pSEL) supplied via the signal line 14B. The processing circuit 36 may include a buffer circuit for outputting signals.

The pixel 12 is typically a unit structure that outputs a pixel signal for forming an image. However, in the case of aiming at, e.g., distance measurement using a TOF method, the pixel 12 does not necessarily need to be a unit structure that outputs a pixel signal for forming an image. That is, the pixel 12 may be a unit structure that outputs a signal for measuring the time at which light arrives and the amount of light.

One signal processing unit 30 is not necessarily provided for each pixel 12, and one signal processing unit 30 may be provided for a plurality of pixels 12. In this case, the signal processing of the plurality of pixels 12 may be sequentially performed using one signal processing unit 30.

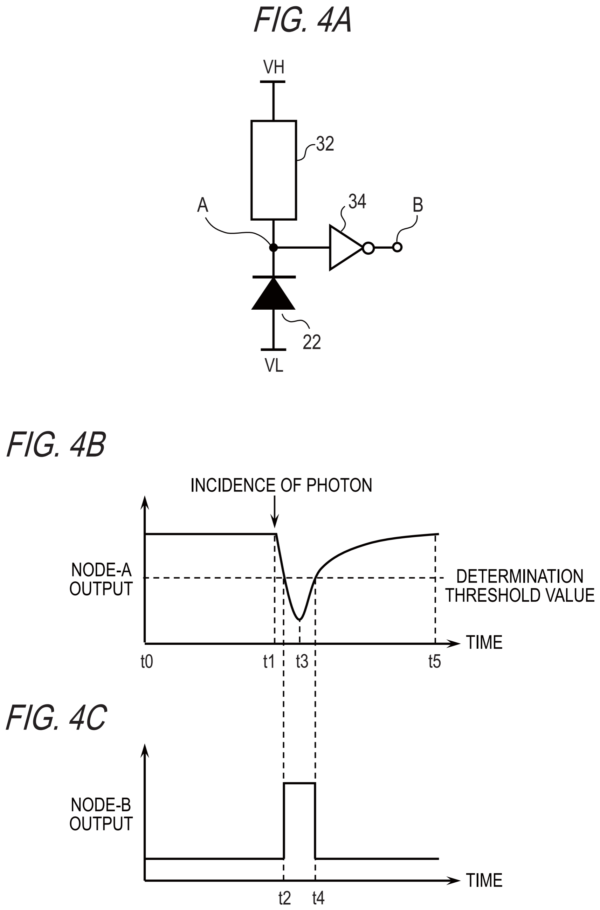

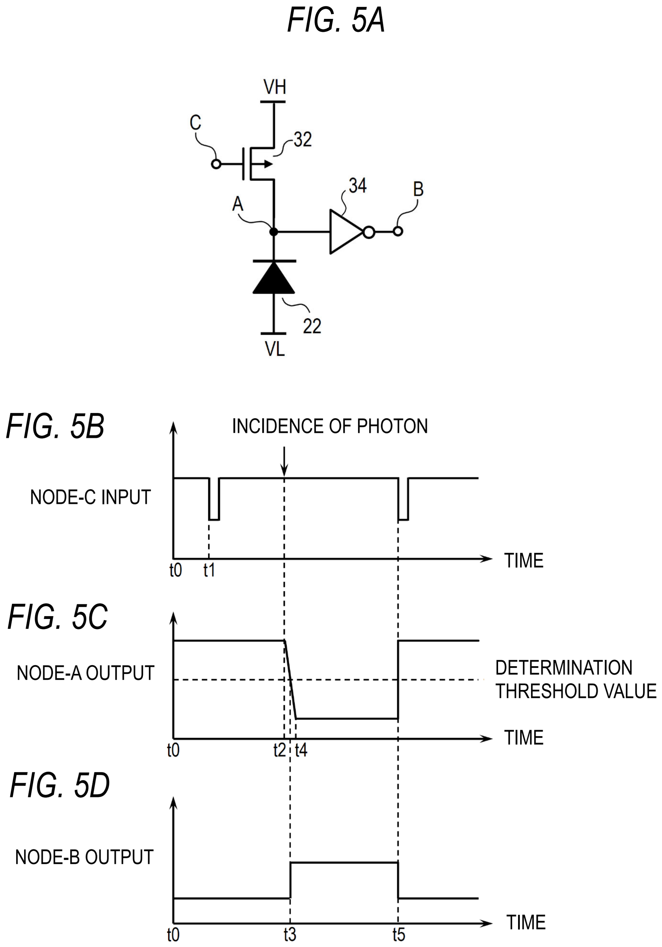

Next, a basic operation of the photoelectric conversion unit 20 in the photoelectric conversion device according to the present embodiment will be described with reference to Fig. 4A to Fig. 5D. Fig. 4A to Fig. 5D are diagrams illustrating basic operations of the photoelectric conversion element 22, the quenching element 32, and the waveform shaping circuit 34 in the photoelectric conversion device according to the present embodiment. Fig. 4A to Fig. 4C illustrate the operation in the case where the quenching element 32 is formed of a passive element, and Fig. 5A to Fig. 5D illustrate the operation in the case where the quenching element 32 is formed of an active element. Here, in order to simplify the description, it is assumed that the waveform shaping circuit 34 is configured by an inverter circuit.

First, an operation in the case where the quenching element 32 is formed of a passive element will be described. Examples of the case where the quenching element 32 is formed of a passive element include a case where the quenching element 32 is formed of a resistor and a case where the quenching element 32 is formed of a diode-connected MOS transistor. Fig. 4A is a circuit diagram of the photoelectric conversion element 22, the quenching element 32, and the waveform shaping circuit 34. Fig. 4B illustrates the waveform of the signal at the input node (node-A) of the waveform shaping circuit 34. Fig. 4C illustrates the waveform of the signal at the output node (node-B) of the waveform shaping circuit 34.

At time t0, a potential difference corresponding to (VH-VL), that is, a reverse bias voltage of (Vbd+Vex) is applied to the photoelectric conversion element 22. Although a reverse bias voltage sufficient to cause avalanche multiplication is applied between the anode and the cathode of the APD constituting the photoelectric conversion element 22, primary carriers for avalanche multiplication do not exist in a state where photons are not incident on the photoelectric conversion element 22. Therefore, avalanche multiplication does not occur in the photoelectric conversion element 22, and no current flows through the photoelectric conversion element 22.

At the subsequent time t1, it is assumed that a photon is incident on the photoelectric conversion element 22. When a photon enters the photoelectric conversion element 22, an electron-hole pair is generated by photoelectric conversion, avalanche multiplication is brought about by these primary carriers, and an avalanche multiplication current flows through the photoelectric conversion element 22. When the avalanche multiplication current flows through the quenching element 32, a voltage drop occurs due to the quenching element 32, and the voltage of the node-A starts to drop. When the voltage drop amount of the node-A becomes large and becomes approximately the voltage Vex, avalanche multiplication is stopped at time t3, and the voltage level of the node-A does not drop any more. The potential at which the avalanche multiplication is stopped is about 0 V, that is, a potential at which the voltage applied to the photoelectric conversion element 22 is about Vbd.

When the avalanche multiplication in the photoelectric conversion element 22 stops, a current that compensates for the voltage drop flows from the node of the voltage VH to the node-A via the quenching element 32, and the voltage of the node-A gradually increases. Thereafter, at time t5, the node-A is settled to the original voltage level.

The waveform shaping circuit 34 binarizes the signal input from the node-A according to a predetermined determination threshold value and outputs the signal from the node-B. Specifically, the waveform shaping circuit 34 outputs a low-level signal from the node-B when the voltage level of the node-A exceeds the determination threshold value and outputs a high-level signal from the node-B when the voltage level of the node-A is equal to or less than the determination threshold value. For example, as illustrated in Fig. 4B, it is assumed that the voltage of the node-A is equal to or lower than the determination threshold value in the period from the time t2 to the time t4. In this case, as illustrated in Fig. 4C, the signal level at the node-B becomes low-level in the period from the time t0 to the time t2 and the period from the time t4 to the time t5, and becomes high-level in the period from the time t2 to the time t4.

Thus, the analog signal input from the node-A is waveform-shaped into a digital signal by the waveform shaping circuit 34. A pulse signal output from the waveform shaping circuit 34 in response to incidence of a photon on the photoelectric conversion element 22 is a photon detection pulse signal.

Next, an operation when the quenching element 32 is formed of an active element will be described. In a case where the quenching element 32 is formed of an active element, for example, a case where the quenching element 32 is formed of a MOS transistor operated by an external control signal may be exemplified. Fig. 5A is a circuit diagram of the photoelectric conversion element 22, the quenching element 32, and the waveform shaping circuit 34. Fig. 5B illustrates the waveform of the signal at the input node (node-C) of the quenching element 32. Fig. 5C illustrates the waveform of the signal at the input node (node-A) of the waveform shaping circuit 34. Fig. 5D illustrates the waveform of the signal at the output node (node-B) of the waveform shaping circuit 34.

In the circuit of Fig. 5A, the quenching element 32 is formed of a p-channel MOS transistor. A source of the p-channel MOS transistor is connected to the node of the voltage VH, and a drain of the p-channel MOS transistor is connected to the cathode of the photoelectric conversion element 22 and the input node of the waveform shaping circuit 34. A connection node between the drain of the p-channel MOS transistor, the cathode of the photoelectric conversion element 22, and the input node of the waveform shaping circuit 34 is a node-A. As illustrated in, e.g., Fig. 5B, a periodic pulse signal (hereinafter referred to as a reset pulse signal) is input to a gate (node-C) of the p-channel MOS transistor. The reset pulse signal is a falling pulse that transitions from high-level to low-level. The p-channel MOS transistor is turned off when the node-C is at high-level to disconnect the node-A from the node of the voltage VH and is turned on when the node-C is at low-level to reset the node-A to the voltage VH.

When the reset pulse signal is input to the node-C at time t1, the p-channel MOS transistor is turned on, and the node-A is reset to the voltage VH. When the node-C returns to high-level, the p-channel MOS transistor is turned off, and the node-A enters a floating state at the voltage VH.

At the subsequent time t2, it is assumed that a photon is incident on the photoelectric conversion element 22. When a photon enters the photoelectric conversion element 22, an electron-hole pair is generated by photoelectric conversion, avalanche multiplication is caused by these carriers as seeds, and an avalanche multiplication current flows through the photoelectric conversion element 22. When the avalanche multiplication current flows through the quenching element 32, a voltage drop occurs due to the quenching element 32, and the voltage of the node-A starts to drop. When the voltage drop amount of the node-A becomes large and becomes approximately the voltage Vex, avalanche multiplication is stopped at time t4, and the voltage level of the node-A does not drop any more. The potential at which the avalanche multiplication is stopped is about 0 V, that is, a potential at which the voltage applied to the photoelectric conversion element 22 is about Vbd. The node-A enters a floating state while being kept at a lowered potential.

When the reset pulse signal is input to the node-C again at time t5, the p-channel MOS transistor is turned on, and the node-A is reset to the voltage VH again.

The waveform shaping circuit 34 binarizes the signal input from the node-A according to a predetermined determination threshold value, and outputs the signal from the node-B. Specifically, the waveform shaping circuit 34 outputs a low-level signal from the node-B when the voltage level of the node-A exceeds the determination threshold value, and outputs a high-level signal from the node-B when the voltage level of the node-A is equal to or less than the determination threshold value. For example, as illustrated in Fig. 5C, it is assumed that the voltage of the node-A is equal to or lower than the determination threshold value in the period from the time t3 to the time t5. In this case, as illustrated in Fig. 5D, the signal level at the node-B becomes low-level in the period from the time t0 to the time t3 and the period after the time t5, and becomes high-level in the period from the time t3 to the time t5.

Thus, the analog signal input from the node-A is waveform-shaped into a digital signal by the waveform shaping circuit 34. A pulse signal output from the waveform shaping circuit 34 in response to incidence of a photon on the photoelectric conversion element 22 is a photon detection pulse signal.

In the operation of Fig. 5A to Fig. 5D, if no photon is incident between time t1 and time t5, the node-A remains at the voltage VH, and the node-B remains at low-level. In addition, in a case where the photon is incident again during a period from the time when the photon is incident at the time t2 to the time t5, that is, in a state where the potential of the node-A is lowered, the photoelectric conversion element 22 cannot cause further avalanche multiplication. Therefore, the number of incidences of photons that can be detected by the waveform shaping circuit 34 in the period from the time t1 to the time t5 is one at most.

As described above, in the operation of Fig. 5A to Fig. 5D, it is possible to distinguish whether the number of photons incident during one period of the reset pulse signal is zero, or one or more. On the other hand, when two or more photons are incident during one period of the reset pulse signal, these photons cannot be distinguished from each other, and there is a possibility that a signal detection loss occurs.

In the case where the photons come continually, in the operation of Fig. 4A to Fig. 4C, the avalanche multiplication in the photoelectric conversion element 22 does not stop and the avalanche current continues to flow, that is, a so-called pile-up state occurs. In this pile-up state, the photon detection pulse signals are not generated, and only the current flows wastefully, which is one major problem in the SPAD operation.

On the other hand, in the operation of Fig. 5A to Fig. 5D, when two or more photons are incident during one period of the reset pulse signal, these photons cannot be distinguished from each other, but there is an advantage that pile-up that may occur in the operation of Fig. 4A to Fig. 4C does not occur. Although signal detection loss may certainly occur in the operation of Fig. 5A to Fig. 5D, the SPAD originally aims at photon detection in a situation where photon incidence is small, and in such a situation, it is rare that photons are incident a plurality of times during one reset pulse period, and signal detection loss hardly occurs. Therefore, when the SPAD is used as, in particular, the image sensor, the operation of Fig. 5A to Fig. 5D is often applied.

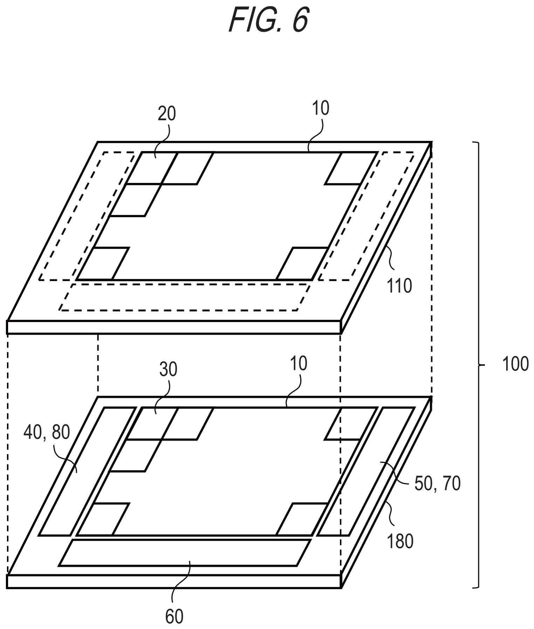

The photoelectric conversion device 100 according to the present embodiment may be formed on one substrate or may be configured as a stacked-type photoelectric conversion device in which a plurality of substrates are stacked. In the latter case, as illustrated in, e.g., Fig. 6, the photoelectric conversion device may be configured as a stacked-type photoelectric conversion device in which a sensor substrate 110 (first substrate) and a circuit substrate 180 (second substrate) are stacked and electrically connected to each other. At least the photoelectric conversion units 20 among the constituent elements of the pixels 12 may be arranged on the sensor substrate 110. In addition, the signal processing units 30 among the constituent elements of the pixels 12 may be arranged on the circuit substrate 180. The photoelectric conversion unit 20 and the signal processing unit 30 are electrically connected to each other via a connection wiring provided for each pixel 12. The circuit substrate 180 may further include the vertical scanning circuit unit 40, the readout circuit unit 50, the horizontal scanning circuit unit 60, the output circuit unit 70, and the control pulse generation unit 80.

The photoelectric conversion unit 20 and the signal processing unit 30 of each pixel 12 may be provided on the sensor substrate 110 and the circuit substrate 180 so as to overlap each other in a plan view. The vertical scanning circuit unit 40, the readout circuit unit 50, the horizontal scanning circuit unit 60, the output circuit unit 70, and the control pulse generation unit 80 may be arranged around the pixel region 10 configured by the plurality of pixels 12. Here, the term "plan view" refers to a view from a direction perpendicular to the surface of the sensor substrate 110.

By configuring the stacked-type photoelectric conversion device 100, it is possible to increase the degree of integration of elements and achieve higher functionality. In particular, by arranging the photoelectric conversion unit 20 and the signal processing unit 30 on different substrates, the photoelectric conversion elements 22 may be arranged at high density without sacrificing the light receiving area of the photoelectric conversion elements 22, and the photon detection efficiency may be improved.

The number of substrates constituting the photoelectric conversion device 100 is not limited to two, and three or more substrates may be stacked to constitute the photoelectric conversion device 100. For example, when the photoelectric conversion device 100 is configured by stacking three substrates, the photoelectric conversion units 20 among the constituent elements of the pixels 12 may be arranged on the sensor substrate. In addition, the functional blocks 30A among the constituent elements of the pixels 12 may be arranged on the first circuit substrate, and the functional blocks 30B among the constituent elements of the pixels 12 may be arranged on the second circuit substrate. By dividing the substrate to be arranged according to the characteristics of the elements constituting each functional block, a suitable manufacturing process may be applied to each element, and the performance of the photoelectric conversion device may be improved.

In Fig. 6, a diced chip is assumed as the sensor substrate 110 and the circuit substrate 180, but the sensor substrate 110 and the circuit substrate 180 are not limited to chips. For example, each of the sensor substrate 110 and the circuit substrate 180 may be a wafer. In addition, the sensor substrate 110 and the circuit substrate 180 may be stacked in a wafer state and then diced, or may be stacked and bonded after being formed into chips.

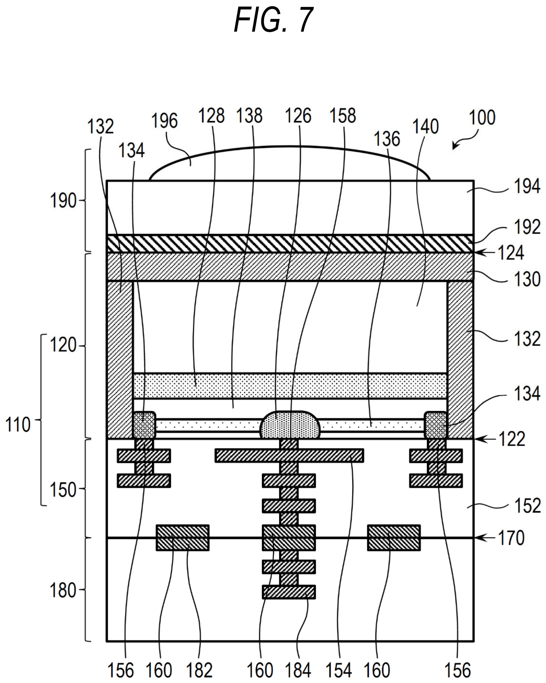

Next, a specific element structure of the photoelectric conversion device 100 according to the present embodiment will be described with reference to Fig. 7. Fig. 7 is a schematic cross-sectional view illustrating the structure of the photoelectric conversion device according to the present embodiment.

As illustrated in, e.g., Fig. 7, the photoelectric conversion device 100 according to the present embodiment may be configured as a stacked-type photoelectric conversion device in which a sensor substrate 110 and a circuit substrate 180 are stacked. The sensor substrate 110 includes a semiconductor layer 120 having a first face 122 and a second face 124 opposite to the first face 122, and an interconnection structure layer 150 provided on a side of the first face 122 of the semiconductor layer 120. An optical structure layer 190 may be arranged on a side of the second face 124 of the semiconductor layer 120. A circuit substrate 180 is stacked on a side of the interconnection structure layer 150 of the sensor substrate 110. The bonding face 170 in Fig. 6 is a bonding portion between the sensor substrate 110 and the circuit substrate 180. In the photoelectric conversion device according to the present embodiment, the side of the second face 124 of the semiconductor layer 120 on which the optical structure layer 190 is provided serves as a light receiving surface on which light to be detected is incident. That is, the photoelectric conversion device according to the present embodiment is a so-called back-illuminated photoelectric conversion device.

The semiconductor layer 120 is formed by thinning a single crystalline silicon substrate, for example, and contains an n-type impurity or a p-type impurity at a predetermined concentration. In the present embodiment, as an example, a semiconductor layer 120 obtained by thinning an n-type silicon substrate having a low impurity concentration is assumed. The photoelectric conversion elements 22 each including n-type semiconductor regions, p-type semiconductor regions, and semiconductor regions are provided in the semiconductor layer 120. A specific structure of the photoelectric conversion element 22 will be described later. The present embodiment is based on a method of detecting a change in the cathode potential as illustrated in Fig. 4A to Fig. 5D. However, a method of detecting a change in the anode potential may be used.

The interconnection structure layer 150 includes an insulating layer 152 and interconnection layers 154 arranged in the insulating layer 152. The interconnection layers 154 include an anode electrode 156 (second electrode) connected to a p-type semiconductor region 136, a cathode electrode 158 (first electrode) connected to an n-type semiconductor region 126, and a pad electrode 160 formed of an interconnection layer farthest from the semiconductor layer 120.

The circuit substrate 180 is stacked on the sensor substrate 110 on a side of the interconnection structure layer 150. The bonding face 170 in Fig. 6 is a bonding portion between the sensor substrate 110 and the circuit substrate 180. The circuit substrate 180 includes a semiconductor layer provided with elements such as transistors and an interconnection structure layer provided on the semiconductor layer. Fig. 7 illustrates only the pad electrodes 182 formed of the uppermost interconnection layer and a part of interconnection layers 184 connected to the pad electrode 182 among the semiconductor layer and the interconnection structure layer constituting the circuit substrate 180 for simplification of the drawing. The sensor substrate 110 and the circuit substrate 180 may be physically and electrically connected to each other by, for example, metal-metal bonding between a metal member constituting the pad electrode 160 and a metal member constituting the pad electrode 182. The circuit substrate 180 may include a plurality of substrates.

The optical structure layer 190 may include a pinning film 192, a planarization layer 194, and a microlens layer including a plurality of microlenses 196. The optical structure layer 190 may further include a filter layer (not illustrated). Various optical filters such as a color filter, an infrared cut filter, and a monochrome filter may be applied to the filter layer. A known material may be applied to the pinning film 192.

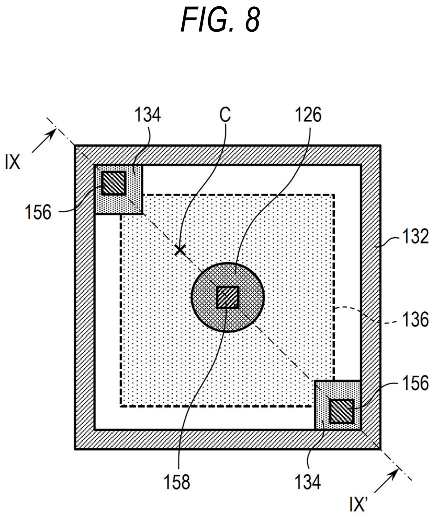

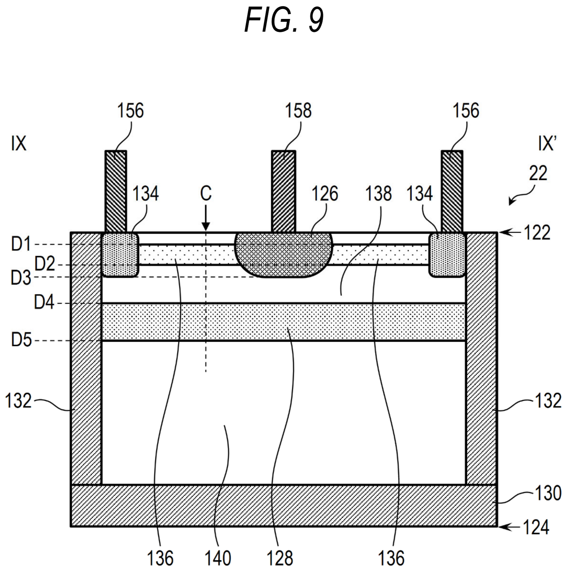

Next, a specific element structure of the photoelectric conversion element 22 in the photoelectric conversion device 100 according to the present embodiment will be described with reference to Fig. 8 and Fig. 9. Fig. 8 is a plan view illustrating the structure of the photoelectric conversion element in the photoelectric conversion device according to the present embodiment. Fig. 9 is a schematic cross-sectional view illustrating the structure of the photoelectric conversion element in the photoelectric conversion device according to the present embodiment. Fig. 8 corresponds to a plan view of the semiconductor layer 120 as viewed from a side of the first face 122. Fig. 9 is a cross-sectional view taken along line IX-IX' of Fig. 8.

As illustrated in Fig. 8 and Fig. 9, the semiconductor layer 120 includes an n-type semiconductor region 126, a p-type semiconductor region 128, 130, 132, 134 and 136, and semiconductor regions 138 and 140. The p-type semiconductor region 130 is provided on a side of the second face 124 of the semiconductor layer 120 in a cross-sectional view. The p-type semiconductor region 130 is provided over the entire region in which the photoelectric conversion element 22 is arranged, and overlaps the n-type semiconductor region 126, the p-type semiconductor region 128, 132, 134 and 136, and the semiconductor regions 138 and 140 in the plan view. When the back-illuminated photoelectric conversion device is configured, the p-type semiconductor region 134 is preferably arranged so as to be in contact with the second face 124. With this configuration, it is possible to prevent dark current from being generated on the second face 124. The p-type semiconductor region 132 is provided at a boundary portion between adjacent photoelectric conversion elements 22. That is, the p-type semiconductor region 132 is provided so as to surround each of the regions in which the photoelectric conversion elements 22 are arranged in the plan view. The p-type semiconductor region 132 is provided from the first face 122 of the semiconductor layer 120 to a depth at which the p-type semiconductor region 130 is arranged. Although one photoelectric conversion element 22 is arranged in the region surrounded by the p-type semiconductor region 132 in Fig. 8 and Fig. 9, two or more photoelectric conversion elements 22 may be arranged in each of the regions surrounded by the p-type semiconductor region 132.

In this specification, the term "plan view" refers to a view from the normal direction of the light incident surface (the second face 124) of the semiconductor layer 120 or the opposite surface (the first face 122). In addition, the "cross-sectional view" refers to viewing a cut surface parallel to the normal direction of the first face 122 or the second face 124 of the semiconductor layer 120 from the normal direction of the cut surface.

The n-type semiconductor region 126, the p-type semiconductor regions 128, 134, and 136, and the semiconductor regions 138 and 140 are provided inside the region surrounded by the p-type semiconductor regions 130 and 132. The n-type semiconductor region 126 is provided on a side of the first face 122 of the semiconductor layer 120 so as to be separated from the p-type semiconductor region 132. The n-type semiconductor region 126 is arranged in a region from the first face 122 to a depth D3. Then, depth means the distance from the first face 122 toward the second face 124 direction. The p-type semiconductor region 128 is provided in a region from a depth D4 on a side of the second face 124 with respect to the depth D3 to a depth D5 on a side of the second face 124 with respect to the depth D4. The p-type semiconductor region 128 is in contact with the p-type semiconductor region 132 in a peripheral portion in the plan view. The p-type semiconductor region 136 is arranged so as to surround the n-type semiconductor region 126 in the plan view from a depth D1 between the first face 122 and a depth D3 to a depth D2 deeper than the depth D1 and equal to or shallower than the depth D3. The p-type semiconductor region 136 is in contact with the n-type semiconductor region 126. In Fig. 8, the p-type semiconductor region 136 is separated from the p-type semiconductor region 132 in the peripheral portion in the plan view but may be in contact therewith. The p-type semiconductor region 134 is provided on a side of the first face 122 of the semiconductor layer 120 so as to be in contact with the p-type semiconductor region 132 and separated from the n-type semiconductor region 126. As illustrated in, e.g., Fig. 8, the p-type semiconductor region 134 may be in contact with the p-type semiconductor region 136. On the other hand, p-type semiconductor region 136 may be separated from the p-type semiconductor region 132 and the p-type semiconductor region 134. A portion of the region from the first face 122 to the depth D4 excluding the n-type semiconductor region 126 and the p-type semiconductor regions 132, 134, and 136 is a semiconductor region 138. A region between the p-type semiconductor region 128 and the p-type semiconductor region 130 is a semiconductor region 140. The conductivity type of each of the semiconductor regions 138 and 140 is not particularly limited and may be an n-type or a p-type.

The n-type semiconductor region 126 constitutes the cathode of the APD and contacts the cathode electrode 158 and is formed of an n-type semiconductor containing a high concentration n-type impurity. The p-type semiconductor region 134 is a portion in contact with the anode electrode 156 of the APD and is formed of a p-type semiconductor containing a high concentration p-type impurity. The p-type semiconductor region 128 is a region serving as an anode of the APD and is formed of a p-type semiconductor containing a p-type impurity. The p-type semiconductor region 128 is provided at a depth closer to the second face 124 than the cathode (the n-type semiconductor region 126) to the second face 124. The p-type semiconductor region 128 is formed over substantially the entire region in which the photoelectric conversion element 22 is arranged. The semiconductor region 140 is a photoelectric conversion region and is formed of a semiconductor containing a low-concentration n-type impurity or p-type impurity. The semiconductor region 138 is formed of a semiconductor containing a low-concentration n-type impurity or p-type impurity, and at least the vicinity of the n-type semiconductor region 126 is depleted during operation.

In the photoelectric conversion element 22 according to the present embodiment, the depletion layer formed in the p-n junction between the n-type semiconductor region 126 and the p-type semiconductor region 128 serves as an avalanche multiplication region. The p-type semiconductor region 132 serves not only as an element isolation portion but also as a path for supplying an anode potential to the p-type semiconductor region 128 constituting the anode of the APD. That is, the anode potential supplied from the anode electrode 156 is supplied to the p-type semiconductor regions 128 and 130 via the p-type semiconductor region 134 and the p-type semiconductor region 132. As a result, the potentials of the p-type semiconductor regions 132, 128, and 130 become the anode potential.

By applying a predetermined reverse bias voltage between the cathode electrode 158 and the anode electrode 156, a high electric field is applied to the p-n junction between the n-type semiconductor region 126 and the p-type semiconductor region 128, and the APD may operate. During the operation of the APD, depletion occurs at least in a portion of the p-type semiconductor region 128 overlapping with the n-type semiconductor region 126 in the plan view so as to penetrate the p-type semiconductor region 128 vertically. As a result, the signal charge generated by the incident photon on the semiconductor region 140 flows into the n-type semiconductor region 126 through the depletion region of the p-type semiconductor region 128 formed just below the cathode and causes avalanche multiplication in this process.

Here, it is known that since the first face 122 of the semiconductor layer 120 is a terminal portion of the atomic arrangement constituting the semiconductor, many semiconductor atoms have dangling bonds and many carrier generation levels exist. Therefore, electron-hole pairs are generated at a high rate from the vicinity of the first face 122 around the cathode which is depleted during the operation of the APD. When a part of them reaches a strong electric field region between the cathode and the anode, avalanche multiplication is caused, which causes an increase in the dark count rate (DCR). Note that the DCR is the number of counts per unit time caused by dark carriers generated in the SPAD. DCR is the main factor of dark noise in SPAD and is desired to be reduced as much as possible.

From such a viewpoint, in the photoelectric conversion element 22 according to the present embodiment, the p-type semiconductor region 136 is provided around the n-type semiconductor region 126 in the plan view. The p-type semiconductor region 136 has a peak of the impurity concentration of the p-type impurity at a depth between the first face 122 and the depth D3. The reason why the photoelectric conversion element 22 according to the present embodiment has such a p-type semiconductor region 136 will be described below.

In this specification, the term "impurity concentration" means an effective impurity concentration, i.e., a net impurity concentration obtained by subtracting an amount offset by an impurity of an opposite conductivity type. That is, the region in which the concentration of the p-type impurity is higher than the concentration of the n-type impurity is a p-type semiconductor region having an impurity concentration obtained by subtracting the concentration of the n-type impurity from the concentration of the p-type impurity. The region in which the concentration of the n-type impurity is higher than the concentration of the p-type impurity is an n-type semiconductor region having an impurity concentration obtained by subtracting the concentration of the p-type impurity from the concentration of the n-type impurity.

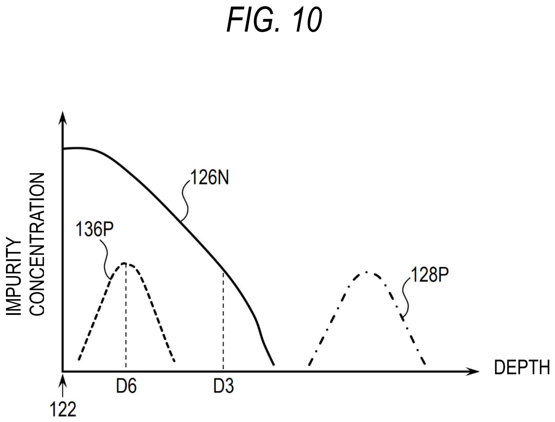

Fig. 10 is a graph illustrating the distribution of impurities in the depth direction along a perpendicular line passing through the center of the n-type semiconductor region 126 in the plan view. The horizontal axis represents the depth in the direction from the first face 122 toward the second face 124, and the vertical axis represents the impurity concentration (logarithmic axis). Fig. 10 illustrates a distribution of the concentration of the n-type impurity 126N constituting the n-type semiconductor region 126, a distribution of the concentration of the p-type impurity 128P constituting the p-type semiconductor region 128, and a distribution of the concentration of the p-type impurity 136P constituting the p-type semiconductor region 136.

The depth D3 in Fig. 10 is the depth of the bottom face of the n-type semiconductor region 126 (cathode), that is, the depth of the n-type semiconductor region 126 on a side of the second face 124. In the operation state of the APD, since the region of the n-type semiconductor region 126 where the concentration of the n-type impurity is about 1×10¹⁷ cm⁻³ or less is depleted, the substantial cathode is a portion of the n-type semiconductor region 126 where the concentration of the n-type impurity is about 1 × 10¹⁷ cm⁻³ or more. Therefore, in the present specification, the depth at which the concentration of the n-type impurity on the side of the p-type semiconductor region 128 is 1×10¹⁷ cm⁻³ is defined as the depth D3 of the bottom face of the n-type semiconductor region 126. A region on a side of the second face 124 deeper than the depth D3 is a high electric field region that causes avalanche multiplication.

The p-type impurity 136P constituting the p-type semiconductor region 136 may be provided not only around the n-type semiconductor region 126 in the plan view but also in a portion overlapping the n-type semiconductor region 126. Therefore, when the depth direction distribution of the impurity along the perpendicular line passing through the center of the n-type semiconductor region 126 is viewed, as illustrated in Fig. 10, the p-type impurity 136P constituting the p-type semiconductor region 136 may exist between the first face 122 and the depth D3. However, since the impurity concentration of the p-type impurity 136P is sufficiently smaller than the impurity concentration of the n-type impurity 126N, the net conductivity type in the portion where the n-type semiconductor region 126 and the p-type semiconductor region 136 overlap is the n-type. The p-type semiconductor region 136 has no specific effect there. Note that providing the p-type semiconductor region 136 in a portion overlapping with the n-type semiconductor region 126 has an advantage that variations in characteristics due to misalignment with the n-type semiconductor region 126 may be prevented.

On the other hand, when paying attention to a region not overlapping the n-type semiconductor region 126 in the plan view, the impurity concentration of the p-type impurity constituting the p-type semiconductor region 136 is higher than the impurity concentration of the impurity constituting the semiconductor region 138, for example, on a perpendicular line passing through the point C (see Fig. 8 and Fig. 9). Therefore, the conductivity type of the portion corresponding to the p-type impurity 136P becomes p-type, and the function of the p-type semiconductor region 136 becomes apparent.

The depth D6 illustrated in Fig. 10 is a depth at which the concentration of the p-type impurity constituting the p-type semiconductor region 136 becomes a peak. The depth D6 is located closer to the second face 124 than the first face 122 to the second face 124. On a perpendicular line passing through the point C, the p-type impurity concentration at the first face 122 and the depth D3 is sufficiently lower than the p-type impurity concentration at the depth D6. That is, the p-type semiconductor region 136 is required to have a steep concentration gradient of the p-type impurity with respect to the depth direction. In this sense, in the region that does not overlap the n-type semiconductor region 126 in the plan view, it is more preferable that the first face 122 and its vicinity and the depth D3 and its vicinity have an n-type conductivity. Note that the case where the conductivity type around the depth D3 is an n-type includes a case where the conductivity type is an n-type at a depth deeper than the depth D3 but closer to the depth D3 and a case where the conductivity type is an n-type at a depth closer to the depth D3 from a location deeper than the depth D6.

Here, in the structure as described above, generation of carriers from the carrier generation level of the first face 122 is considered. As described above, during the operation of the SPAD, the region around the n-type semiconductor region 126 is depleted regardless of its conductivity type. Then, carriers are generated at a high rate from the interface states of the depleted first face 122. When a direction parallel to the first face 122 and the second face 124 is defined as a lateral direction, a lateral component of the electric field is large around the n-type semiconductor region 126 in the plan view. Therefore, electrons generated on the first face 122 perform drift motion toward the n-type semiconductor region 126 serving as the cathode, and holes generated on the first face 122 perform drift motion toward the p-type semiconductor region 128 serving as the anode. These carriers cause avalanche multiplication and are counted as DCR when these carriers reach the high electric field region between the n-type semiconductor region 126 and the p-type semiconductor region 128.

At this time, since the p-type semiconductor region 136 serves as a potential barrier with respect to electrons, the region of the first face 122 and the vicinity thereof serves as a stable region having a minimum potential with respect to electrons generated in the vicinity of the first face 122. On the other hand, the p-type semiconductor region 136 becomes a stable region having a minimum potential with respect to holes generated in the vicinity of the first face 122. Therefore, both electrons and holes generated in the vicinity of the first face 122 are prevented from diffusing in the depth direction by the p-type semiconductor region 136 and do not easily reach the high electric field region.

That is, in the periphery of the n-type semiconductor region 126 in the plan view, the first face 122 and the vicinity thereof serve as an electron draining path, and the p-type semiconductor region 136 serves as a hole draining path. It is more effective that the conductivity type of the first face 122 and the vicinity thereof around the n-type semiconductor region 126 is an n-type in forming the electron draining path. However, in the periphery of the n-type semiconductor region 126 in the plan view, even when the conductivity type of the first face 122 and its vicinity and the depth D3 and its vicinity is p-type, the draining path may be formed depending on the condition. According to the consideration and simulation of the inventors, it is possible to form an electron draining path, being less effective than the n type first face and its vicinity, by setting the p-type impurity concentration in the first face 122 and its vicinity and the depth D3 and its vicinity to be equal to or less than one half of the peak impurity concentration of the p-type semiconductor region 136. In other words, in at least one of the first face 122 and its vicinity and the depth D3 and its vicinity, the p-type impurity concentration may be set to be equal to or less than one half of the peak impurity concentration of the p-type semiconductor region 136, or an n-type semiconductor region may be provided. When the n-type semiconductor region is provided, the maximum impurity concentration in the n-type semiconductor region is set to be lower than the maximum impurity concentration in the n-type semiconductor region 126.

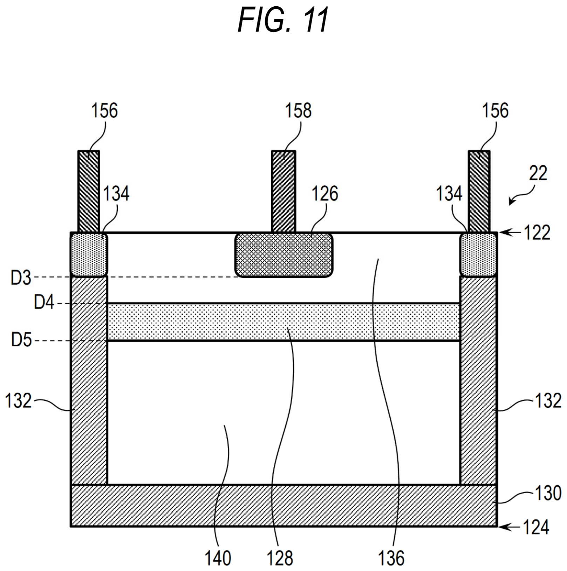

Fig. 11 is a schematic cross-sectional view illustrating a structure of a photoelectric conversion element according to a reference example. In the photoelectric conversion element 22 according to the reference example, the p-type semiconductor region 136 having a uniform low impurity concentration is provided around the n-type semiconductor region 126 over the region of the depth D4 from the first face 122 of the semiconductor layer. In this structure, when the p-type semiconductor region 136 is depleted, the potential of the p-type semiconductor region 136 is affected by the cathode potential of the n-type semiconductor region 126 and becomes high on the first face 122, becomes low in the depth direction, and rather becomes a potential gradient that pushes holes in the deeper direction. Electrons may also diffuse in a deep direction at locations away from the n-type semiconductor region 126. As a result, in this structure, no carrier draining path is formed, and DCR caused by carriers generated on the first face 122 of the semiconductor layer cannot be reduced.

The effect of the present embodiment becomes more remarkable in the case of a structure in which the first face 122 and its vicinity and the depth D3 and its vicinity around the n-type semiconductor region 126 in the plan view have an n-type conductivity. Therefore, the n-type impurity may be actively introduced into the depth of the first face 122 and the vicinity thereof and the depth D3 and the vicinity thereof to provide the n-type semiconductor region. The n-type semiconductor region may be provided in substantially the same region as the p-type semiconductor region 136 in the plan view or may be provided in the entire region where the photoelectric conversion element 22 is arranged.

Although the p-type semiconductor region 136 and the p-type semiconductor region 134 are directly connected in the configuration examples of Fig. 8 and Fig. 9, the p-type semiconductor region 136 is not necessarily directly connected to the p-type semiconductor region 134. For example, even if an n-type semiconductor region having a low impurity concentration exists between the p-type semiconductor region 134 and the p-type semiconductor region 136, the p-type semiconductor region 136 may function as a hole draining path to the p-type semiconductor region 134 as long as the n-type semiconductor region is depleted during operation. The p-type semiconductor region 136 may be directly connected to the p-type semiconductor region 134 or the p-type semiconductor region 132. In addition, in the configuration examples of Fig. 8 and Fig. 9, two p-type semiconductor regions 134 are arranged, but the present embodiment is not limited thereto, and one p-type semiconductor region 134 may be arranged, or three or more p-type semiconductor regions 134 may be arranged.

As described above, according to the present embodiment, the p-type semiconductor region having the peak of the impurity concentration is provided around the cathode at a position shallower than the bottom face of the cathode, whereby it is possible to reduce noise caused by carriers generated from the carrier generation level in the photoelectric conversion element, in particular at the first semiconductor face 122.

### Second Embodiment

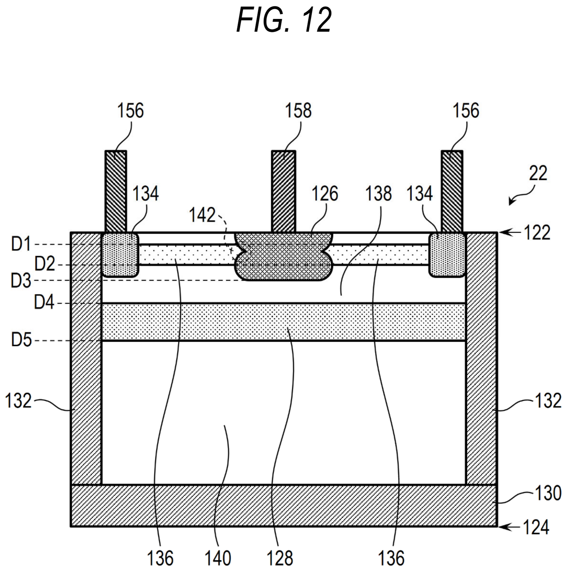

A photoelectric conversion device according to a second embodiment will be described with reference to Fig. 12. Fig. 12 is a schematic cross-sectional view illustrating a structure of a photoelectric conversion element in the photoelectric conversion device according to the present embodiment. The same components as those of the photoelectric conversion device according to the first embodiment are denoted by the same reference numerals, and description thereof will be omitted or simplified.

The photoelectric conversion device according to the present embodiment is the same as the photoelectric conversion device according to the first embodiment except that the structure of the photoelectric conversion element 22 is different. In the present embodiment, differences between the photoelectric conversion element of the present embodiment and the photoelectric conversion element of the first embodiment will be mainly described, and description of portions common to the photoelectric conversion element of the first embodiment will be appropriately omitted.

The photoelectric conversion element 22 of the present embodiment is different from the photoelectric conversion element of the first embodiment in that the structure of the n-type semiconductor region 126 is different. That is, as illustrated in Fig. 12, the n-type semiconductor region 126 of the photoelectric conversion element 22 of the present embodiment has a narrow portion 142 in the depth direction. The narrow portion 142 of the n-type semiconductor region 126 is located at the same depth as the depth at which the p-type semiconductor region 136 is arranged, and more preferably, in the vicinity of a depth D6 at which the concentration of the p-type impurity constituting the p-type semiconductor region 136 becomes a peak.

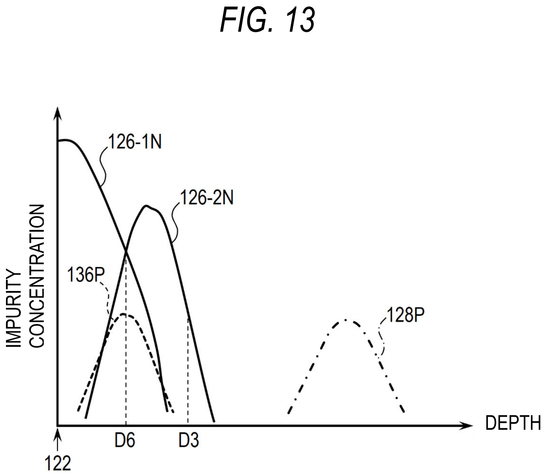

Fig. 13 is a graph illustrating the distribution of impurities in the depth direction along a perpendicular line passing through the center of the n-type semiconductor region 126. The horizontal axis represents the depth in the direction from the first face 122 toward the second face 124, and the vertical axis represents the impurity concentration (logarithmic axis). Fig. 13 illustrates a distribution of the concentration of the n-type impurities 126-1N and 126-2N constituting the n-type semiconductor region 126, a distribution of the concentration of the p-type impurities 128P constituting the p-type semiconductor region 128, and a distribution of the concentration of the p-type impurities 136P constituting the p-type semiconductor region 136.

The n-type semiconductor region 126 in the photoelectric conversion element 22 of the present embodiment may be formed, for example, by performing ion implantation of an n-type impurity a plurality of times under conditions of different projection ranges. In Fig. 13, the n-type impurity 126-1N indicates the distribution of the n-type impurity ions implanted under the condition that the projection range becomes shallower than the depth D6, and the n-type impurity 126-2N indicates the distribution of the n-type impurity ions implanted under the condition that the projection range becomes deeper than the depth D6. Here, the n-type semiconductor regions formed by the ion implantation are referred to as n-type semiconductor regions 126-1 and 126-2, respectively. The projected range of the implanted ions may be arbitrarily changed by appropriately setting the acceleration energy according to the ion species.

The n-type semiconductor region 126-1 has a peak of the concentration of the n-type impurity closer to the first face 122 than the depth D6 to the first face 122. The n-type semiconductor region 126-2 has a peak of the concentration of the n-type impurity on a side of the second face 124 deeper than the bottom face of a side of the second face 124 of the n-type semiconductor region 126-1. The n-type semiconductor regions 126-1 and 126-2 are provided so that at least a part of a tail portion of the n-type semiconductor region 126-1 on a side of the second face 124 overlaps with at least a part of a tail portion of the n-type semiconductor region 126-2 on a side of the first face 122. The n-type semiconductor region 126-1 and the n-type semiconductor region 126-2 are electrically connected to each other at their overlapping portions and have substantially the same potential. That is, in the photoelectric conversion element 22 of the present embodiment, the n-type semiconductor region 126-1 and the n-type semiconductor region 126-2 integrally constitute one cathode. A connection portion between the n-type semiconductor region 126-1 and the n-type semiconductor region 126-2 is located at a depth at which the p-type semiconductor region 136 is arranged.

The impurities doped by ion implantation are distributed not only in the depth direction but also in the horizontal direction. The smaller the area of the region to be doped and the deeper the formation position, the larger a curvature in a center portion of a convex shape of the cross-sectional shape of the semiconductor region to be formed. This is because the concentration of the impurities constituting the semiconductor region becomes lower as the distance from the center portion becomes larger due to the distribution of the impurities, and the impurity distribution tends to expand as the formation position becomes deeper. As a result, the widths of the n-type semiconductor regions 126-1 and 126-2 in the plan view in the vicinity of the depth D6 at which the tail of the n-type semiconductor region 126-1 and the tail of the n-type semiconductor region 126-2 overlap each other are smaller than the maximum widths of the n-type semiconductor regions 126-1 and 126-2 in the plan view. This portion corresponds to the narrow portion 142 of the n-type semiconductor region 126.

The n-type semiconductor regions 126-1 and 126-2 may have the same shape in the plan view, but need not necessarily have the same shape and may have different sizes in the plan view. However, when the n-type semiconductor regions 126-1 and 126-2 have substantially the same shape in the plan view, they may be formed through the same mask process, which is advantageous in that the manufacturing process may be simplified.

The p-type semiconductor region 136 may be provided at substantially the same depth as the overlapping depth of the n-type semiconductor region 126-1 and the n-type semiconductor region 126-2. The peak impurity concentration of the p-type semiconductor region 136 is preferably lower than the concentration of the n-type impurity at the depth where the n-type semiconductor region 126-1 and the n-type semiconductor region 126-2 overlap each other. This is because, if the concentration of the p-type impurity constituting the p-type semiconductor region 136 is higher than the concentration of the n-type impurity, there is a possibility that electrical conduction between the n-type semiconductor region 126-1 and the n-type semiconductor region 126-2 cannot be maintained.

Also in the present embodiment, the depth D3 at which the n-type impurity concentration on a side of the p-type semiconductor region 128 is 1×10¹⁷ cm⁻³ in the cathode region constituted by the n-type semiconductor region 126 is defined as the bottom face of the cathode. The reason why the bottom face of the cathode is defined based on the n-type impurity concentration of 1×10¹⁷ cm⁻³ is the same as in the first embodiment. A region on a side of the second face 124 deeper than the depth D3 is a high electric field region that causes avalanche multiplication. Since the p-type semiconductor region 136 is provided at substantially the same depth as the depth at which the n-type semiconductor region 126-1 and the n-type semiconductor region 126-2 overlap each other, the depth D3 of the bottom face of the cathode is located closer to the second face 124 than the depth D6 to the second face 124 at which the concentration of the p-type impurity 136P is at a peak.

In general, in the SPAD of a charge collection type, the cathode size is small with respect to the pixel size, and when a high voltage is applied between the anode and the cathode during operation, lines of electric force are concentrated on the cathode, and the electric field strength increases at a location close to the cathode. On the other hand, electrons generated at the first face 122 drift toward the cathode in the first face 122 and the vicinity thereof and are accelerated by the electric field in the vicinity of the cathode. At this time, a part of the electrons accelerated by the electric field in the vicinity of the cathode maintains kinetic energy even when the electrons enter a portion close to the cathode end of the neutral region in the cathode and may cause impact ionization. The holes of the carrier pairs generated by the impact ionization move to the neutral region close to the end of the cathode by diffusion.

In the structure of the photoelectric conversion element according to the first embodiment or the photoelectric conversion element according to the reference example, holes generated in the neutral region inside the cathode by the above-described mechanism reach the bottom portion of the cathode with a certain probability by diffusion. The bottom of the cathode is the place where the electric field intensity is the highest in the photoelectric conversion element, and the probability of occurrence of avalanche multiplication is the highest. Therefore, the holes reaching the bottom of the cathode may be detected as DCR in this manner.

Also in the photoelectric conversion element 22 of the present embodiment, holes may be generated by impact ionization at the cathode in contact with the first face 122, that is, at the end of the n-type semiconductor region 126. However, as illustrated in Fig. 12, the cathode of the photoelectric conversion element 22 of the present embodiment has a narrow portion 142 at a depth where the n-type semiconductor region 126-1 and the n-type semiconductor region 126-2 overlap each other. As described above, the narrow portion 142 is generated because the n-type semiconductor region 126-2 has a convex shape and the peak depth of the impurity concentration is at a position deeper than the bottom face of the n-type semiconductor region 126-1.

The periphery of the n-type semiconductor regions 126-1 and 126-2 in the plan view is depleted and an electric field in the lateral direction is generated, but in the narrow portion 142 of the cathode, the depleted region has such a shape as to encroach into the cathode. The holes generated in the neutral region close to the end portion of the n-type semiconductor region 126 tend to diffuse in the deeper direction (direction to the second face 124) but exit to the outside of the n-type semiconductor region 126 at the narrow portion 142 and are drained as they are through the p-type semiconductor region 136 which is a hole draining path. Therefore, holes hardly reach the bottom of the cathode, that is, the depth D3 of the bottom of the n-type semiconductor region 126 and may be prevented from being counted as DCR. In order to further clarify the narrow structure of the cathode, a p-type impurity may be further introduced to a depth substantially the same as that of the narrow portion 142 in a region substantially the same as that of the n-type semiconductor region 126 in the plan view.

In the periphery of the n-type semiconductor region 126 in the plan view, the first face 122 and the vicinity thereof and the depth D3 and the vicinity thereof may be an n-type semiconductor region or a p-type semiconductor region having a p-type impurity concentration equal to or less than one half of the peak impurity concentration of the p-type semiconductor region 136.

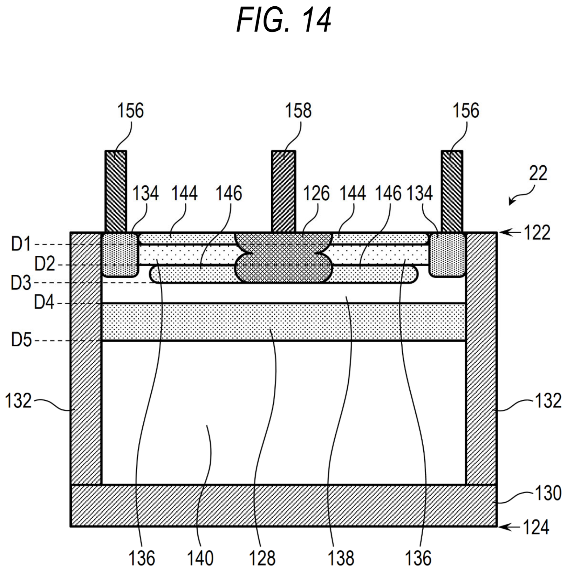

Fig. 14 is a schematic cross-sectional view illustrating a structure of a photoelectric conversion element according to a modification of the present embodiment. The photoelectric conversion element illustrated in Fig. 14 further includes n-type semiconductor regions 144 and 146 in addition to the components of the photoelectric conversion element illustrated in Fig. 12. The n-type semiconductor region 144 is provided at a depth of the first face 122 and the vicinity thereof around the n-type semiconductor region 126 in the plan view. The n-type semiconductor region 146 is provided at a position deeper than the peak depth of the p-type semiconductor region 136 around the n-type semiconductor region 126 in the plan view. In other words, the n-type semiconductor region 146 is arranged in a region overlapping the p-type semiconductor region 136 in the plan view so as to have a peak of impurity concentration between the p-type semiconductor region 136 and the depth D3.

In the photoelectric conversion element illustrated in Fig. 14, the n-type semiconductor region 144 functions as an electron draining path, and the p-type semiconductor region 136 functions as a potential barrier for electrons. While the p-type semiconductor region 136 functions as a hole draining path, the n-type semiconductor region 146 serves as a potential barrier for holes and may effectively prevent holes in the p-type semiconductor region 136 from diffusing to a deeper side. Accordingly, the DCR reduction effect may be further enhanced. The maximum impurity concentration in the n-type semiconductor regions 144 and 146 is set to be lower than the maximum impurity concentration in the n-type semiconductor region 126.

As described above, according to the present embodiment, the p-type semiconductor region having the peak of the impurity concentration at a position shallower than the bottom face of the cathode is provided around the cathode, whereby it is possible to reduce noise caused by carriers generated from the carrier generation level in the photoelectric conversion element. In addition, by providing the narrow portion in the depth direction of the cathode, carriers generated from the carrier generation level may be more effectively drained, and noise may be further reduced.

### Third Embodiment

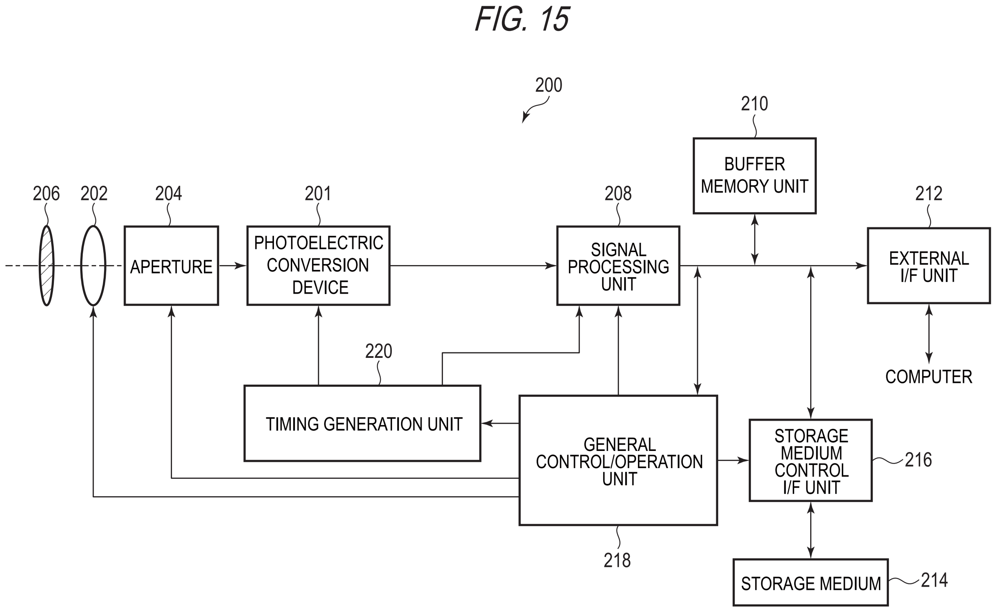

A photodetection system according to a third embodiment will be described with reference to Fig. 15. Fig. 15 is a block diagram illustrating a schematic configuration of a photodetection system according to the present embodiment. In the present embodiment, a photodetection sensor to which the photoelectric conversion device 100 according to the first or second embodiment is applied will be described.

The photoelectric conversion device 100 described in the first or second embodiment may be applied to various photodetection systems. Examples of applicable photodetection systems include imaging systems such as digital still cameras, digital camcorders, surveillance cameras, copying machines, facsimiles, mobile phones, on-vehicle cameras, observation satellites, and the like. A camera module including an optical system such as a lens and an imaging device is also included in the photodetection system. Fig. 15 exemplifies a block diagram of a digital still camera as one of these.

The photodetection system 200 illustrated in Fig. 15 includes a photoelectric conversion device 201, a lens 202 that forms an optical image of an object on the photoelectric conversion device 201, an aperture 204 for varying the amount of light passing through the lens 202, and a barrier 206 for protecting the lens 202. The lens 202 and the aperture 204 form an optical system that focuses light onto the photoelectric conversion device 201. The photoelectric conversion device 201 is the photoelectric conversion device 100 described in the first or second embodiment, and converts the optical image formed by the lens 202 into image data.

The photodetection system 200 further includes a signal processing unit 208 that processes an output signal output from the photoelectric conversion device 201. The signal processing unit 208 generates image data from the digital signal output from the photoelectric conversion device 201. Further, the signal processing unit 208 performs various corrections and compressions as necessary and outputs the processed image data. The photoelectric conversion device 201 may include an AD conversion unit that generates a digital signal to be processed by the signal processing unit 208. The AD conversion unit may be formed on a semiconductor layer (semiconductor substrate) in which the photoelectric conversion element of the photoelectric conversion device 201 is formed or may be formed on a semiconductor layer different from the semiconductor layer in which the photoelectric conversion element of the photoelectric conversion device 201 is formed. The signal processing unit 208 may be formed on the same semiconductor layer as the photoelectric conversion device 201.

The photodetection system 200 further includes a buffer memory unit 210 for temporarily storing image data, and an external interface unit (external I/F unit) 212 for communicating with an external computer or the like. Further, the photodetection system 200 includes a storage medium 214 such as a semiconductor memory for performing storing or reading out of imaging data, and a storage medium control interface unit (storage medium control I/F unit) 216 for performing storing on or reading out from the storage medium 214. The storage medium 214 may be built in the photodetection system 200 or may be detachable. Communication between the storage medium control I/F unit 216 and the storage medium 214 and communication from the external I/F unit 212 may be performed wirelessly.

The photodetection system 200 further includes a general control/operation unit 218 that performs various calculations and controls the entire digital still camera, and a timing generation unit 220 that outputs various timing signals to the photoelectric conversion device 201 and the signal processing unit 208. Here, the timing signal or the like may be input from the outside, and the photodetection system 200 may include at least the photoelectric conversion device 201 and the signal processing unit 208 that processes the output signal output from the photoelectric conversion device 201. The timing generation unit 220 may be mounted on the photoelectric conversion device 201. Further, the general control/operation unit 218 and the timing generation unit 220 may be configured to perform a part or all of the control functions of the photoelectric conversion device 201.

The photoelectric conversion device 201 outputs an imaging signal to the signal processing unit 208. The signal processing unit 208 performs predetermined signal processing on the imaging signal output from the photoelectric conversion device 201 and outputs image data. The signal processing unit 208 generates an image using the imaging signal. The signal processing unit 208 may be configured to perform distance measurement calculation on the signal output from the photoelectric conversion device 201.

As described above, according to the present embodiment, by configuring the photodetection system using the photoelectric conversion device according to the first or second embodiment, it is possible to realize the photodetection system capable of acquiring a higher quality image.

### Fourth Embodiment

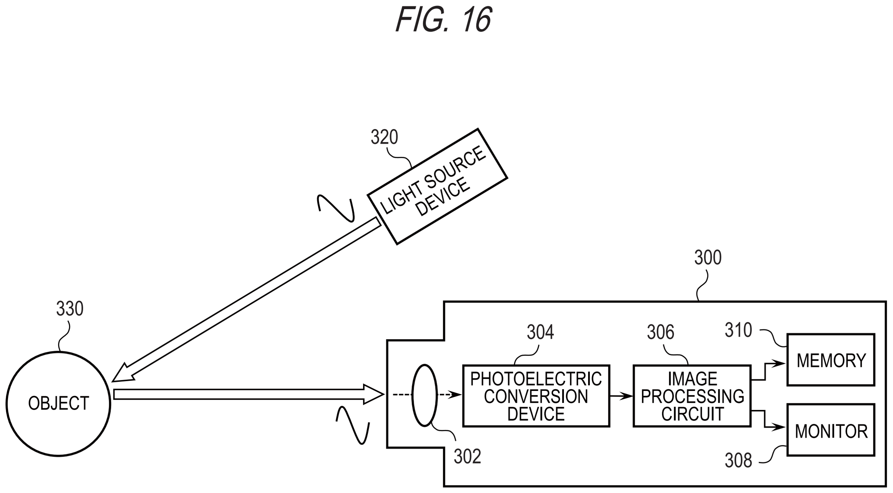

A range image sensor according to a fourth embodiment will be described with reference to Fig. 16. Fig. 16 is a block diagram illustrating a schematic configuration of a range image sensor according to the present embodiment. In the present embodiment, a range image sensor will be described as an example of a photodetection system to which the photoelectric conversion device 100 according to the first or second embodiment is applied.

As illustrated in Fig. 16, the range image sensor 300 according to the present embodiment may include an optical system 302, a photoelectric conversion device 304, an image processing circuit 306, a monitor 308, and a memory 310. The range image sensor 300 receives light (modulated light or pulsed light) emitted from a light source device 320 toward an object 330 and reflected on the surface of the object 330 and acquires a distance image corresponding to the distance to the object 330.

The optical system 302 includes one or a plurality of lenses and has a function of forming an image of image light (incident light) from the object 330 on a light receiving surface (sensor unit) of the photoelectric conversion device 304.

The photoelectric conversion device 304 is the photoelectric conversion device 100 described in the first or second embodiment and has a function of generating a distance signal indicating a distance to the object 330 based on image light from the object 330 and supplying the generated distance signal to the image processing circuit 306.

The image processing circuit 306 has a function of performing image processing for constructing a distance image based on the distance signal supplied from the photoelectric conversion device 304.

The monitor 308 has a function of displaying a distance image (image data) obtained by image processing in the image processing circuit 306. The memory 310 has a function of storing (recording) a distance image (image data) obtained by image processing in the image processing circuit 306.

As described above, according to the present embodiment, by configuring the range image sensor using the photoelectric conversion device according to the first or second embodiment, it is possible to realize a range image sensor capable of acquiring a range image including more accurate range information in conjunction with improvement in characteristics of the pixels 12.

### Fifth Embodiment

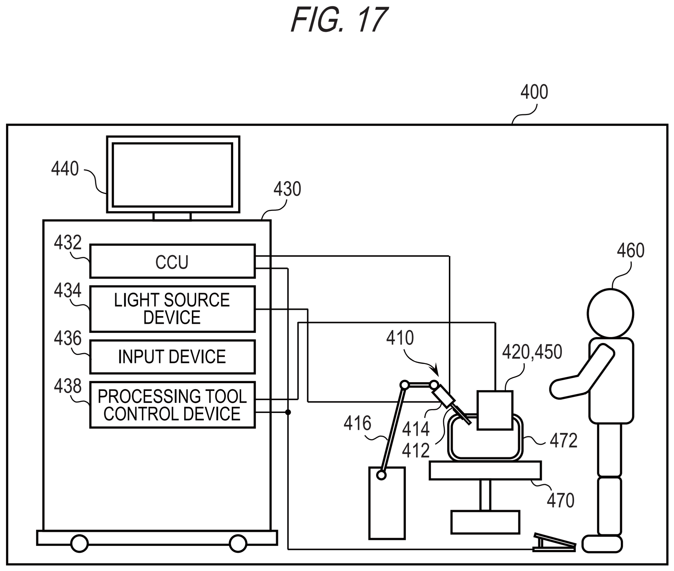

An endoscopic surgical system according to a fifth embodiment will be described with reference to Fig. 17. Fig. 17 is a schematic diagram illustrating a configuration example of an endoscopic surgical system according to the present embodiment. In the present embodiment, an endoscopic surgical system will be described as an example of a photodetection system to which the photoelectric conversion device 100 according to the first or second embodiment is applied.

Fig. 17 illustrates a state in which an operator (surgeon) 460 performs surgery on a patient 472 on a patient bed 470 using an endoscopic surgical system 400.

As illustrated in Fig. 17, the endoscopic surgical system 400 according to the present embodiment may include an endoscope 410, a surgical tool 420, and a cart 430 on which various devices for endoscopic surgery are mounted. A camera control unit (CCU) 432, a light source device 434, an input device 436, a processing tool control device 438, a display device 440, and the like may be mounted on the cart 430.

The endoscope 410 includes a lens barrel 412 in which an area of a predetermined length from the tip is inserted into a body cavity of the patient 472, and a camera head 414 connected to the base end of the lens barrel 412. Although Fig. 17 illustrates an endoscope 410 configured as a so-called rigid mirror having a rigid lens barrel 412, the endoscope 410 may be configured as a so-called flexible mirror having a flexible lens barrel. The endoscope 410 is held in a movable state by an arm 416.

The tip of the lens barrel 412 is provided with an opening into which an objective lens is fitted. A light source device 434 is connected to the endoscope 410, and light generated by the light source device 434 is guided to the tip of the lens barrel 412 by a light guide extended inside the lens barrel and is irradiated toward an observation target in the body cavity of the patient 472 through the objective lens. Note that the endoscope 410 may be a direct-viewing mirror, an oblique-viewing mirror, or a side-viewing mirror.

An optical system and a photoelectric conversion device (not illustrated) are provided inside the camera head 414, and reflected light (observation light) from the observation target is focused on the photoelectric conversion device by the optical system. The photoelectric conversion device photoelectrically converts the observation light and generates an electrical signal corresponding to the observation light, that is, an image signal corresponding to the observation image. As the photoelectric conversion device, the photoelectric conversion device 100 described in the first or second embodiment may be used. The image signal is transmitted to the CCU 432 as RAW data.

The CCU 432 may be configured by a central processing unit (CPU), a graphics processing unit (GPU), or the like, and integrally controls operations of the endoscope 410 and the display device 440. Further, the CCU 432 receives an image signal from the camera head 414 and performs various types of image processing for displaying an image based on the image signal, such as development processing (demosaic processing), on the image signal.

The display device 440 displays an image based on the image signal subjected to the image processing by the CCU 432 under the control of the CCU 432.

The light source device 434 may be configured by, for example, a light source such as a light emitting diode (LED), and supplies irradiation light to the endoscope 410 when photographing a surgical part or the like.

The input device 436 is an input interface to the endoscopic surgical system 400. The user may input various kinds of information and input instructions to the endoscopic surgical system 400 via the input device 436.

The processing tool control device 438 controls the driving of the energy processing tool 450 for tissue ablation, incision, blood vessel sealing, or the like.

The light source device 434 that supplies irradiation light to the endoscope 410 when imaging the surgical part may be configured by, for example, a white light source configured by an LED, a laser light source, or a combination thereof. When the white light source is configured by a combination of the RGB laser light sources, since the output intensity and the output timing of each color (each wavelength) may be controlled with high accuracy, the white balance of the captured image may be adjusted in the light source device 434. In addition, in this case, it is also possible to capture an image corresponding to each of RGB in a time division manner by irradiating the observation target with laser light from each of the RGB laser light sources in a time division manner and controlling driving of the imaging element of the camera head 414 in synchronization with the irradiation timing. According to this method, a color image may be obtained without providing a color filter in the image sensor.

Further, the driving of the light source device 434 may be controlled so as to change the intensity of light to be output every predetermined time. By controlling the driving of the image sensor of the camera head 414 in synchronization with the timing of the change of the intensity of the light to acquire an image in a time division manner and compositing the image, it is possible to generate an image having a high dynamic range free from so-called blacked up shadows and blown out highlights.

The light source device 434 may be configured to be capable of supplying light in a predetermined wavelength band corresponding to special light observation. In the special light observation, for example, wavelength dependency of absorption of light in body tissue is utilized. Specifically, a predetermined tissue such as a blood vessel in the superficial layer of a mucous membrane is photographed with high contrast by irradiating light in a narrow band as compared with irradiation light (that is, white light) at the time of normal observation. Alternatively, in the special light observation, fluorescence observation in which an image is obtained by fluorescence generated by irradiation with excitation light may be performed. In the fluorescence observation, a body tissue is irradiated with excitation light to observe fluorescence from the body tissue, or a body tissue is locally injected with a reagent such as indocyanine green (ICG), and the body tissue is irradiated with excitation light corresponding to a fluorescence wavelength of the reagent to obtain a fluorescence image. The light source device 434 may be configured to be capable of supplying narrowband light and/or excitation light corresponding to such special light observation.

As described above, according to the present embodiment, by configuring the endoscopic surgical system using the photoelectric conversion device according to the first or second embodiment, it is possible to realize the endoscopic surgical system capable of acquiring a higher quality image.

### Sixth Embodiment

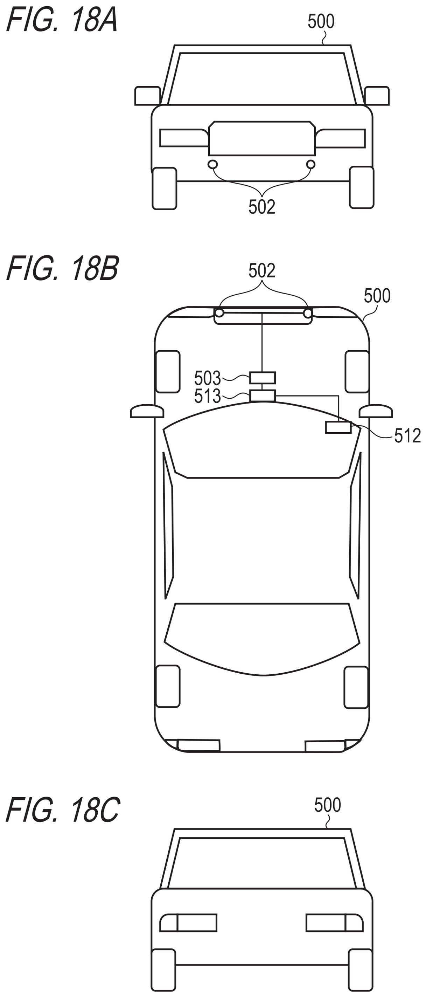

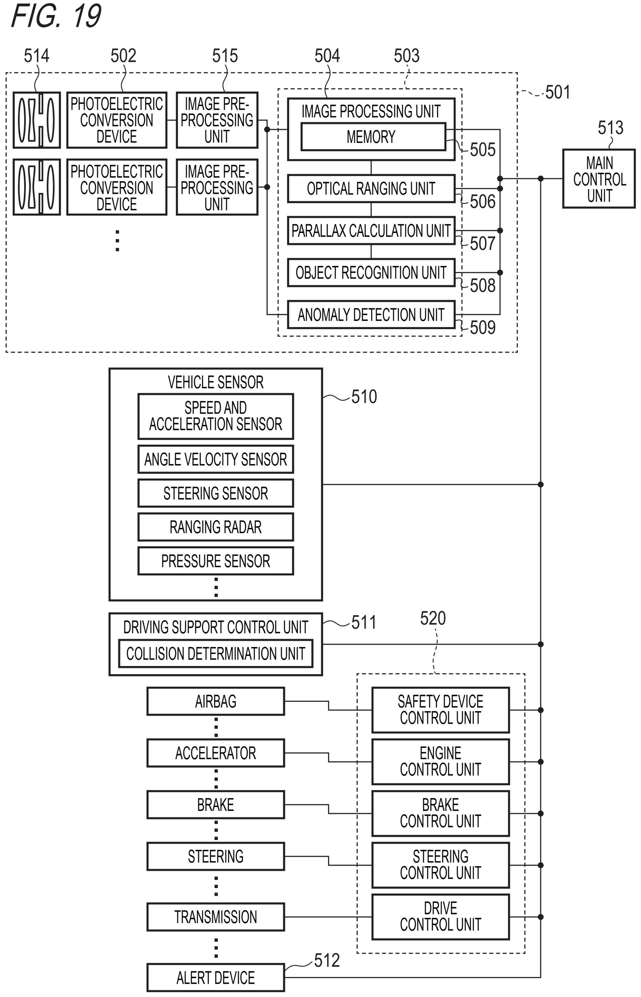

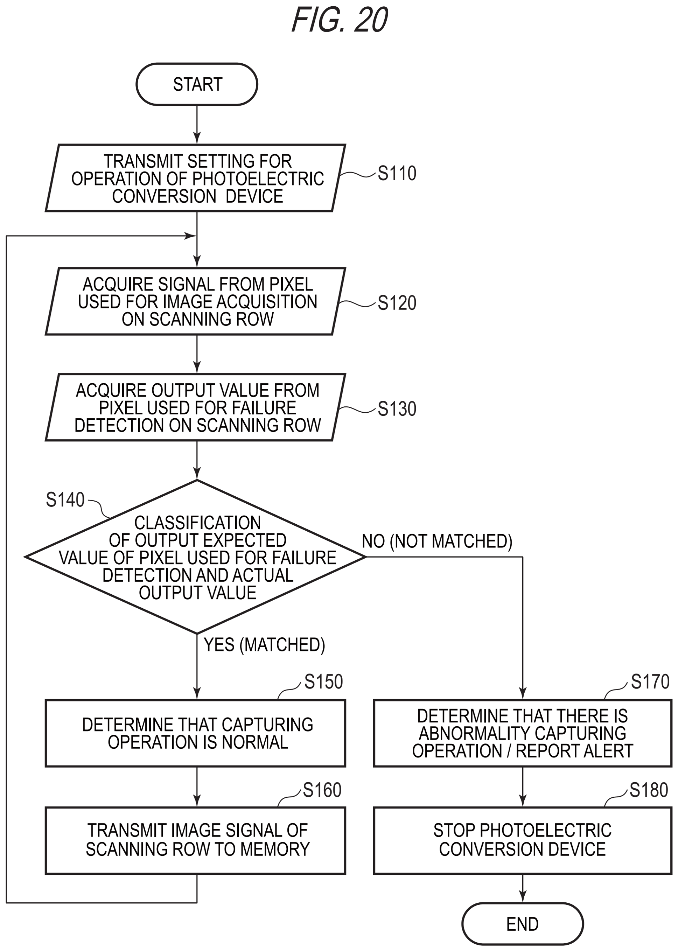

A photodetection system and a movable object according to a sixth embodiment will be described with reference to Fig. 18A to Fig. 20. Fig. 18A to Fig. 18C are schematic diagrams illustrating a configuration example of a movable object according to the present embodiment. Fig. 19 is a block diagram illustrating a schematic configuration of a photodetection system according to the present embodiment. Fig. 20 is a flowchart illustrating an operation of the photodetection system according to the present embodiment. In the present embodiment, an application example to an on-vehicle camera will be described as a photodetection system to which the photoelectric conversion device 100 according to the first or second embodiment is applied.

Fig. 18A to Fig. 18C are schematic diagrams illustrating a configuration example of a movable object (vehicle system) according to the present embodiment. Fig. 18A to Fig. 18C illustrate a configuration of a vehicle 500 (automobile) as an example of a vehicle system incorporating a photodetection system to which the photoelectric conversion device according to the first or second embodiment is applied. Fig. 18A is a schematic front view of the vehicle 500, Fig. 18B is a schematic plan view of the vehicle 500, and Fig. 18C is a schematic rear view of the vehicle 500. The vehicle 500 includes a pair of photoelectric conversion devices 502 on a front face thereof. Here, the photoelectric conversion device 502 is the photoelectric conversion device 100 described in the first or second embodiment. The vehicle 500 includes an integrated circuit 503, an alert device 512, and a main control unit 513.

Fig. 19 is a block diagram illustrating a configuration example of the photodetection system 501 mounted on the vehicle 500. The photodetection system 501 includes photoelectric conversion devices 502, image preprocessing units 515, an integrated circuit 503, and optical systems 514. The photoelectric conversion device 502 is the photoelectric conversion device 100 described in the first or second embodiment. The optical system 514 forms an optical image of an object on the photoelectric conversion device 502. The photoelectric conversion device 502 converts the optical image of the object formed by the optical system 514 into an electrical signal. The image preprocessing unit 515 performs predetermined signal processing on the signal output from the photoelectric conversion device 502. The function of the image preprocessing unit 515 may be incorporated in the photoelectric conversion device 502. At least two sets of the optical system 514, the photoelectric conversion device 502, and the image preprocessing unit 515 are provided in the photodetection system 501, and an output from the image processing unit 515 of each set is input to the integrated circuit 503.

The integrated circuit 503 is an integrated circuit for an imaging system application and includes an image processing unit 504, an optical ranging unit 506, a parallax calculation unit 507, an object recognition unit 508, and an abnormality detection unit 509. The image processing unit 504 processes the image signal output from the image preprocessing unit 515. For example, the image processing unit 504 performs image processing such as development processing and defect correction on the output signal of the image preprocessing unit 515. The image processing unit 504 includes a memory 505 that temporarily holds the image signal. In the memory 505, for example, the position of a known defective pixel in the photoelectric conversion device 502 may be stored.

The optical ranging unit 506 performs focusing and distance measurement of the object. The parallax calculation unit 507 calculates distance measurement information (distance information) from a plurality of image data (parallax images) acquired by the plurality of photoelectric conversion devices 502. Each of the photoelectric conversion devices 502 may have a configuration capable of acquiring various kinds of information such as distance information. The object recognition unit 508 recognizes an object such as a vehicle, a road, a sign, or a person. Upon detecting an abnormality in the photoelectric conversion device 502, the abnormality detection unit 509 notifies the main control unit 513 of the abnormality.

The integrated circuit 503 may be realized by dedicatedly designed hardware, may be realized by a software module, or may be realized by a combination of these. Further, it may be realized by a field programmable gate array (FPGA), an application specific integrated circuit (ASIC), or the like, or may be realized by a combination of these.

The main control unit 513 integrally controls the operations of the photodetection system 501, the vehicle sensor 510, the control unit 520, and the like. The vehicle 500 may not include the main control unit 513. In this case, the photoelectric conversion device 502, the vehicle sensor 510, and the control unit 520 transmit and receive control signals via a communication network. For example, a controller area network (CAN) standard may be applied to the transmission and reception of the control signals.

The integrated circuit 503 has a function of receiving a control signal from the main control unit 513 or transmitting a control signal or a setting value to the photoelectric conversion device 502 by its own control unit.

The photodetection system 501 is connected to the vehicle sensor 510 and may detect a traveling state of the host vehicle such as a vehicle speed, a yaw rate, and a steering angle, an environment outside the host vehicle, and states of other vehicles and obstacles. The vehicle sensor 510 is also a distance information acquisition unit that acquires distance information to the object. In addition, the photodetection system 501 is connected to a driving support control unit 511 that performs various kinds of driving support such as automatic steering, automatic traveling, and a collision prevention function. In particular, with respect to the collision determination function, the driving support control unit 511 estimates the collision with other vehicles or obstacles and determines whether or not there is a collision with other vehicles or obstacles based on the detection results of the photodetection system 501 and the vehicle sensor 510. Thus, avoidance control when a collision is estimated and activation of the safety device at the time of the collision are performed.

The photodetection system 501 is also connected to an alert device 512 that issues an alert to the driver based on the determination result of the collision determination unit. For example, when the determination result of the collision determination unit is that the possibility of a collision is high, the main control unit 513 performs vehicle control for avoiding a collision and reducing damage by applying a brake, returning an accelerator, suppressing engine output, or the like. The alert device 512 alerts the user by sounding an alarm such as a sound, displaying alert information on a display screen of a car navigation system, a meter panel, or the like, or vibrating a seat belt or a steering wheel.

In the present embodiment, an image of the surroundings of the vehicle, for example, the front or the rear, is captured by the photodetection system 501. Fig. 18B illustrates an arrangement example of the photodetection system 501 in a case where the photodetection system 501 captures an image in front of the vehicle.

As described above, the photoelectric conversion devices 502 are arranged in front of the vehicle 500. Specifically, it is preferable that a center line with respect to an advancing/retreating direction or an outer shape (for example, a vehicle width) of the vehicle 500 is regarded as a symmetry axis, and two photoelectric conversion devices 502 are arranged line-symmetrically with respect to the symmetry axis in order to acquire distance information between the vehicle 500 and an object to be imaged and determine a possibility of collision. In addition, the photoelectric conversion device 502 is preferably arranged so as not to interfere with the driver's visual field when the driver visually recognizes a situation outside the vehicle 500 from the driver's seat. The alert device 512 is preferably arranged so as to easily enter the field of view of the driver.

Next, a failure detection operation of the photoelectric conversion device 502 in the photodetection system 501 will be described with reference to Fig. 20. The failure detection operation of the photoelectric conversion device 502 may be performed in accordance with steps S110 to S180 illustrated in Fig. 20.

Step S110 is a step of performing setting at the time of start-up of the photoelectric conversion device 502. That is, the setting for the operation of the photoelectric conversion device 502 is transmitted from the outside of the photodetection system 501 (for example, the main control unit 513) or the inside of the photodetection system 501, and the imaging operation and the failure detection operation of the photoelectric conversion device 502 are started.

Next, in step S120, pixel signals are acquired from the effective pixels. In step S130, an output value from a failure detection pixel provided for failure detection is acquired. The failure detection pixel may include a photoelectric conversion element in the same manner as the effective pixel. A predetermined voltage is written to the photoelectric conversion element of the failure detection pixel. The failure detection pixel outputs a signal corresponding to the voltage written in the photoelectric conversion element. Note that step S120 and step S130 may be reversed.

Next, in step S140, a classification of the output expected value of the failure detection pixel and the actual output value from the failure detection pixel is performed. As a result of the classification in step S140, if the output expected value matches the actual output value, the process proceeds to step S150, it is determined that the imaging operation is normally performed, and the process step proceeds to step S160. In step S160, the pixel signals of the scanning row are transmitted to the memory 505 and temporarily stored. After that, the process returns to step S120 to continue the failure detection operation. On the other hand, as a result of the classification in step S140, if the output expected value does not coincide with the actual output value, the process proceeds to step S170. In step S170, it is determined that there is an abnormality in the imaging operation, and an alert is notified to the main control unit 513 or the alert device 512. The alert device 512 causes the display unit to display that an abnormality has been detected. Thereafter, in step S180, the photoelectric conversion device 502 is stopped, and the operation of the photodetection system 501 is ended.

In addition, in the present embodiment, an example in which the flowchart is looped for each row is described, but the flowchart may be looped for each plurality of rows, or the failure detection operation may be performed for each frame. The alert of step S170 may be notified to the outside of the vehicle via a wireless network.

In addition, in the present embodiment, the control in which the own vehicle does not collide with another vehicle has been described, but the present embodiment is also applicable to control in which the own vehicle follows another vehicle and performs automatic driving, control in which the vehicle performs automatic driving so as not to protrude from a lane, and the like. Further, the photodetection system 501 is not limited to a vehicle such as an own vehicle, and may be applied to, for example, other movable objects (mobile device) of a ship, an aircraft, an industrial robot, or the like. In addition, the present disclosure is not limited to the movable object and may be widely applied to equipment using object recognition, such as intelligent transport systems (ITS).

### Seventh Embodiment

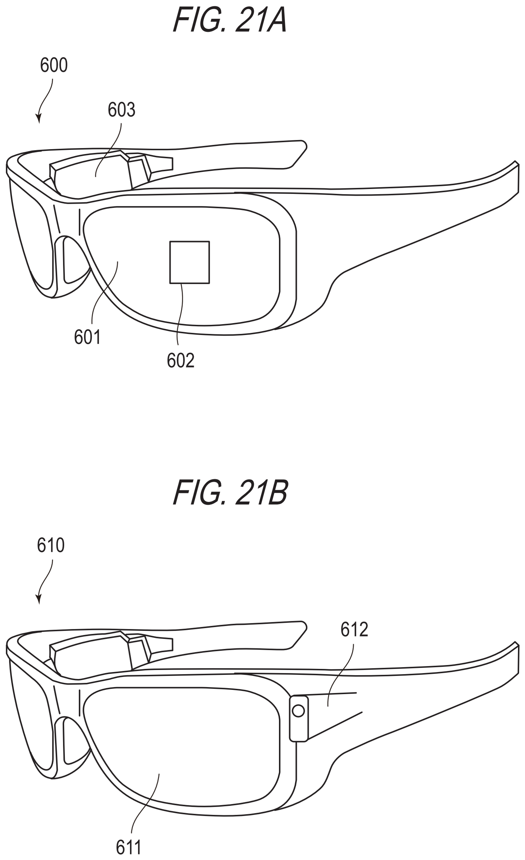

A photodetection system according to a seventh embodiment will be described with reference to Fig. 21A and Fig. 21B. Fig. 21A and Fig. 21B are schematic diagrams illustrating configuration examples of the photodetection system according to the present embodiment. In the present embodiment, an application example to eyeglasses (smart glasses) will be described as a photodetection system to which the photoelectric conversion device 100 according to the first or second embodiment is applied.

Fig. 21A illustrates eyeglasses 600 (smart glasses) according to one application example. The eyeglasses 600 include lenses 601, a photoelectric conversion device 602, and a control device 603.

The photoelectric conversion device 602 is the photoelectric conversion device 100 described in the first or second embodiment and is provided on the lens 601. One photoelectric conversion device 602 may be provided, or a plurality of photoelectric conversion devices may be provided. When a plurality of photoelectric conversion devices 602 are used, a combination of a plurality of types of photoelectric conversion devices 602 may be used. The arrangement position of the photoelectric conversion device 602 is not limited to Fig. 21A. A display device (not illustrated) including a light emitting device such as an organic light emitting diode (OLED) or an LED may be provided on the back surface side of the lens 601.

The control device 603 functions as a power supply that supplies power to the photoelectric conversion device 602 and the display device. The control device 603 has a function of controlling the operations of the photoelectric conversion device 602 and the display device. The lens 601 may be provided with an optical system for focusing light on the photoelectric conversion device 602.

Fig. 21B illustrates eyeglasses 610 (smart glasses) according to another application example. The eyeglasses 610 include lenses 611 and a control device 612. A photoelectric conversion device (not illustrated) corresponding to the photoelectric conversion device 602 and the display device may be mounted on the control device 612.

The lens 611 is provided with a photoelectric conversion device in the control device 612 and an optical system for projecting light from the display device, and an image is projected thereon. The control device 612 functions as a power supply that supplies power to the photoelectric conversion device and the display device and has a function of controlling operations of the photoelectric conversion device and the display device.

The control device 612 may further include a line-of-sight detection unit that detects the line of sight of the wearer. In this case, an infrared light emitting unit may be provided in the control device 612, and infrared light emitted from the infrared light emitting unit may be used for detection of a line of sight. Specifically, the infrared light emitting unit emits infrared light to the eyeball of the user who is watching the display image. A captured image of the eyeball is obtained by detecting reflected light of the emitted infrared light from the eyeball by an imaging unit having a light receiving element. By providing a reduction unit that reduces light from the infrared light emitting unit to the display unit in a plan view, it is possible to reduce degradation of image quality.

The line of sight of the user with respect to the display image may be detected from the captured image of the eyeball obtained by capturing the infrared light. Any known technique may be applied to the line-of-sight detection using the captured image of the eyeball. As an example, a line-of-sight detection method based on a Purkinje image due to reflection of irradiation light on the cornea may be used. More specifically, the line-of-sight detection process based on the pupil corneal reflection method is performed. The line of sight of the user may be detected by calculating a line-of-sight vector representing the orientation (rotation angle) of the eyeball based on the image of the pupil included in the captured image of the eyeball and the Purkinje image using the pupil corneal reflex method.

The display device according to the present embodiment may include a photoelectric conversion device having a light receiving element and may be configured to control a display image based on line-of-sight information of a user from the photoelectric conversion device. Specifically, the display device determines, based on the line-of-sight information, a first viewing area that the user gazes at and a second viewing area other than the first viewing area. The first viewing area and the second viewing area may be determined by a control device of the display device or may be determined by an external control device. When the determination is made by the external control device, the determination result may be transmitted to the display device via communication. In the display area of the display device, the display resolution of the first viewing area may be controlled to be higher than the display resolution of the second viewing area. That is, the resolution of the second viewing area may be lower than the resolution of the first viewing area.

The display area may include a first display area and a second display area different from the first display area, and an area having a high priority may be determined from the first display area and the second display area based on the line-of-sight information. The first display area and the second display area may be determined by a control device of the display device or may be determined by an external control device. When the determination is made by the external control device, the determination result may be transmitted to the display device via communication. The resolution of the high priority area may be controlled to be higher than the resolution of the area other than the high priority area. That is, the resolution of the area having a relatively low priority may be lowered.

Note that an artificial intelligence (Al) may be used to determine the first viewing area or the area with a high priority. The Al may be a model configured to estimate an angle of the line of sight and a distance to a target object ahead of the line of sight from the image of the eyeball using the image of the eyeball and the direction in which the eyeball of the image is actually viewed as teacher data. The Al program may be included in the display device, the photoelectric conversion device, or the external device. When the external device has the program, the information may be transmitted to the display device via communication.

In the case of performing display control based on visual recognition detection, the present disclosure may be preferably applied to smart glasses further including a photoelectric conversion device that captures an image of the outside. Smart glasses may display captured external information in real time.

### Eighth Embodiment

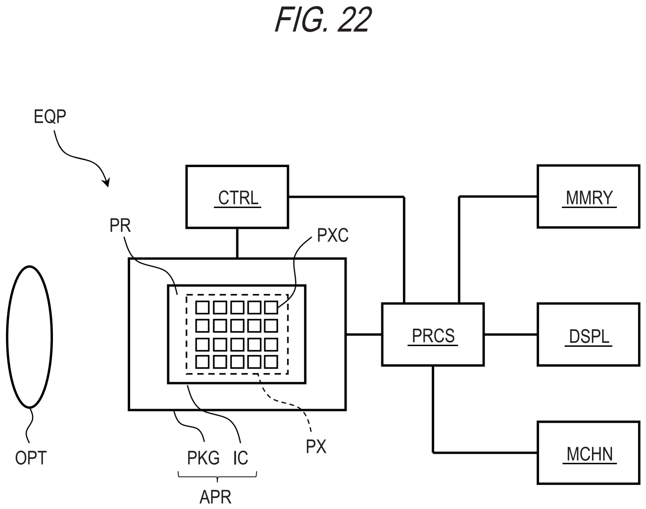

An equipment according to an eighth embodiment will be described with reference to Fig. 22. Fig. 22 is a block diagram illustrating a schematic configuration of an equipment according to the present embodiment.

Fig. 22 is a schematic diagram illustrating an equipment EQP including a photoelectric conversion device APR. The photoelectric conversion device APR has the function of the photoelectric conversion device 100 according to the first or second embodiment. All or part of the photoelectric conversion device APR is a semiconductor device IC. The photoelectric conversion device APR of the present example may be used as, for example, an image sensor, an auto focus (AF) sensor, a photometric sensor, or a distance measurement sensor. The semiconductor device IC includes a pixel region PX in which pixel circuits PXC each including a photoelectric conversion unit are arranged in a matrix. The semiconductor device IC may include a peripheral region PR around the pixel region PX. A circuit other than the pixel circuit may be arranged in the peripheral region PR.

The photoelectric conversion device APR may have a structure (chip stacked structure) in which a first semiconductor chip provided with a plurality of photoelectric conversion units and a second semiconductor chip provided with peripheral circuits are stacked. Each of the peripheral circuits in the second semiconductor chip may be column circuits corresponding to pixel columns of the first semiconductor chip. The peripheral circuits in the second semiconductor chip may be matrix circuits corresponding to pixels or pixel blocks in the first semiconductor chip. As the connection between the first semiconductor chip and the second semiconductor chip, a through electrode (through silicon via (TSV)), an inter-chip wiring by direct bonding of a conductor such as copper, a connection by a micro bump between chips, a connection by wire bonding, or the like may be employed.

The photoelectric conversion device APR may include a package PKG that accommodates the semiconductor device IC in addition to the semiconductor device IC. The package PKG may include a base body to which the semiconductor device IC is fixed, a lid body such as glass facing the semiconductor device IC, and connection members such as bonding wires or bumps for connecting terminals provided on the base body and terminals provided on the semiconductor device IC.

The equipment EQP may further include at least one of an optical device OPT, a control device CTRL, a processing device PRCS, a display device DSPL, a storage device MMRY, and a mechanical device MCHN. The optical device OPT corresponds to the photoelectric conversion device APR as a photoelectric conversion device, and is, for example, a lens, a shutter, or a mirror. The control device CTRL controls the photoelectric conversion device APR, and is, for example, a semiconductor device such as an ASIC. The processing device PRCS processes a signal output from the photoelectric conversion device APR and constitutes an analog front end (AFE) or a digital front end (DFE). The processing unit PRCS is a semiconductor device such as a CPU or an ASIC. The display device DSPL may be an EL display device or a liquid crystal display device that displays information (image) obtained by the photoelectric conversion device APR. The storage device MMRY may be a magnetic device or a semiconductor device that stores information (image) obtained by the photoelectric conversion device APR. The storage device MMRY may be a volatile memory such as an SRAM or a DRAM, or a nonvolatile memory such as a flash memory or a hard disk drive. The mechanical device MCHN may include a movable portion or a propulsion portion such as a motor or an engine. In the equipment EQP, a signal output from the photoelectric conversion device APR is displayed on the display device DSPL or transmitted to the outside by a communication device (not illustrated) included in the equipment EQP. Therefore, it is preferable that the equipment EQP further include a storage device MMRY and a processing device PRCS separately from the storage circuit unit and the arithmetic circuit unit included in the photoelectric conversion device APR.

The equipment EQP illustrated in Fig. 22 may be an electronic device such as an information terminal (for example, a smartphone or a wearable terminal) having a photographing function or a camera (for example, an interchangeable lens camera, a compact camera, a video camera, and a monitoring camera). The mechanical device MCHN in the camera may drive components of the optical device OPT for zooming, focusing, and shutter operation. The equipment EQP may be a transportation device (movable object) such as a vehicle, a ship, or an aircraft. The equipment EQP may be a medical device such as an endoscope or a CT scanner.

The mechanical device MCHN in the transport device may be used as a mobile device. The equipment EQP as a transport device is suitable for transporting the photoelectric conversion device APR, or for assisting and/or automating operation (manipulation) by an imaging function. The processing device PRCS for assisting and/or automating driving (manipulation) may perform processing for operating the mechanical device MCHN as a mobile device based on information obtained by the photoelectric conversion device APR.

The photoelectric conversion device APR according to the present embodiment may provide a high value to a designer, a manufacturer, a seller, a purchaser, and/or a user thereof. Therefore, when the photoelectric conversion device APR is mounted on the equipment EQP, the value of the equipment EQP may also be increased. Therefore, in manufacturing and selling the equipment EQP, it is advantageous to determine the mounting of the photoelectric conversion device APR of the present embodiment on the equipment EQP in order to increase the value of the equipment EQP.

### Modified Embodiments

The present disclosure is not limited to the above embodiments, and various modifications are possible.

For example, an example in which a part of the configuration of any of the embodiments is added to another embodiment or an example in which a part of the configurations of any of the embodiments is substituted with some of the configurations of another embodiment is also an embodiment of the present disclosure.

Further, the circuit configuration of the pixel 12 is not limited to the above-described embodiments. For example, a switch such as a transistor may be provided between the photoelectric conversion element 22 and the quenching element 32 or between the photoelectric conversion element 22 and the signal processing unit 30 to control the electrical connection state therebetween. Further, a switch such as a transistor may be provided between the node to which the voltage VH is supplied and the quenching element 32 and/or between the node to which the voltage VL is supplied and the photoelectric conversion element 22 to control an electrical connection state therebetween. A plurality of photoelectric conversion elements 22 may be provided for one pixel 12.

Further, in the circuit configuration of the pixel 12 of the above-described embodiments, the signal charge (electrons) is taken out from the cathode side with the anode side of the APD as the fixed potential, but the signal charge (holes) may be taken out from the anode side with the cathode side of the APD as the fixed potential. In this case, the conductivity types of the semiconductor regions described in the above embodiment may be opposite to each other.

Further, in the above-described embodiments, an application example to a so-called back-illuminated photoelectric conversion device has been described, but the above-described embodiments may also be applied to a so-called front-illuminated photoelectric conversion device. The front-illuminated photoelectric conversion device is configured to photoelectrically convert light incident from a side of the first face 122 of the semiconductor layer 120 in the semiconductor region 140, but the structure of the photoelectric conversion element 22 may be the same as that of the above-described embodiments.

Further, in the above embodiments, a configuration in which a counter circuit is used as the processing circuit 36 has been described, but a time to digital converter (TDC) and a memory may be used instead of the counter circuit. In this case, the generation timing of the pulse signal output from the waveform shaping circuit 34 is converted into a digital signal by the TDC. A control pulse pREF (reference signal) is supplied to the TDC from the vertical scanning circuit unit 40 via the control line 14 when the timing of the pulse signal is measured. The TDC acquires, as a digital signal, a signal when an input timing of a signal output from each pixel 12 is set to a relative time with reference to the control pulse pREF.

Various embodiments have been described in detail above but it will be understood that the present disclosure is not limited to these embodiments and encompasses all modifications, variants, alternatives and equivalents falling within the scope of the appended claims.

## Claims

1. A photoelectric conversion element (22), provided in a semiconductor layer (120) having a first face (122) and a second face (124) opposite to the first face (122), comprising:
a first semiconductor region (126) of a first conductivity type arranged over a first depth (D3) from the first face (122);
a second semiconductor region (136) of a second conductivity type arranged to surround the first semiconductor region (126) in a plan view and having a peak of an impurity concentration at a second depth between the first face (122) and the first depth (D3); and
a third semiconductor region (128) of the second conductivity type arranged closer to the second face (124) than the first semiconductor region (126) to the second face (124) and constituting an avalanche photodiode with the first semiconductor region (126),
wherein a boundary face of the second semiconductor region (136) on a side of the second face (122) is located closer to the first face (122) than the first depth (D3) to the first face (122).

2. The photoelectric conversion element according to claim 1, wherein a boundary face of the second semiconductor region on a side of the first face is located on a side deeper than the first face with respect to the first face.

3. The photoelectric conversion element according to claim 1 or 2, wherein a width of the first semiconductor region in the plan view at a depth at which the second semiconductor region is arranged is smaller than a maximum width of the first semiconductor region in the plan view.

4. The photoelectric conversion element according to any one of claims 1 to 3, wherein the first semiconductor region includes
a fourth semiconductor region of the first conductivity type arranged to be in contact with the first face and having a peak of an impurity concentration on a side of the first face than the second depth, and
a fifth semiconductor region of the first conductivity type having a peak of an impurity concentration at a depth between the second depth and the first depth and being in contact with the fourth semiconductor region at a depth at which the second semiconductor region is arranged.

5. The photoelectric conversion element according to any one of claims 1 to 4, further comprising: a sixth semiconductor region of the first conductivity type arranged in a region overlapping the second semiconductor region in the plan view at a depth closer to the first face than the second semiconductor region to the first face.

6. The photoelectric conversion element according to claim 5, wherein a maximum impurity concentration in the sixth semiconductor region is lower than a maximum impurity concentration in the first semiconductor region.

7. The photoelectric conversion element according to any one of claims 1 to 6, wherein an impurity concentration of the second semiconductor region at the first depth in a region overlapping the second semiconductor region in the plan view is equal to or less than one half of an impurity concentration of the second semiconductor region at the second depth.

8. The photoelectric conversion element according to any one of claims 1 to 6, further comprising: a seventh semiconductor region of the first conductivity type arranged in a region overlapping the second semiconductor region in the plan view and having a peak of an impurity concentration at a depth between the second semiconductor region and the first depth.

9. The photoelectric conversion element according to claim 8, wherein a maximum impurity concentration of the seventh semiconductor region is lower than a maximum impurity concentration of the first semiconductor region.

10. The photoelectric conversion element according to any one of claims 1 to 9, wherein an impurity concentration of the second semiconductor region at the second depth is lower than an impurity concentration of the first semiconductor region at the second depth.

11. The photoelectric conversion element according to claim 10, wherein an impurity of the second conductivity type constituting the second semiconductor region is doped in a region overlapping the first semiconductor region in the plan view.

12. The photoelectric conversion element according to any one of claims 1 to 11, further comprising: an eighth semiconductor region arranged closer to the second face than the third semiconductor region to the second face,
wherein the avalanche photodiode is configured to multiply signal charge generated in the eighth semiconductor region.

13. The photoelectric conversion element according to any one of claims 1 to 12, wherein a periphery of the first semiconductor region is depleted during operation of the avalanche photodiode.

14. The photoelectric conversion element according to any one of claims 1 to 12, further comprising:
a ninth semiconductor region of the second conductivity type arranged to surround a region where the first semiconductor region, the second semiconductor region, and the third semiconductor region are arranged in the plan view, and connected to the third semiconductor region at a peripheral edge portion of the third semiconductor region in the plan view; and
a tenth semiconductor region of the second conductivity type provided in contact with the second face, overlapping the first semiconductor region, the second semiconductor region, and the third semiconductor region in the plan view, and connected to the ninth semiconductor region.

15. The photoelectric conversion element according to claim 14, further comprising:
a first electrode connected to the first semiconductor region; and
a second electrode connected to the ninth semiconductor region.

16. The photoelectric conversion element according to claim 1, wherein the second semiconductor region is formed by ion implantation.

17. A photoelectric conversion device comprising:
a plurality of pixels arranged to form a plurality of rows and a plurality of columns,
wherein each of the plurality of pixels includes the photoelectric conversion element according to any one of claims 1 to 16 and a signal processing circuit configured to process a signal output from the photoelectric conversion element.

18. The photoelectric conversion device according to claim 17, further comprising:
a first substrate including the semiconductor layer provided with the photoelectric conversion element of each of the plurality of pixels, and
a second substrate provided with the signal processing circuit of each of the plurality of pixels.

19. An equipment comprising:
the photoelectric conversion device according to claim 17 or 18; and
at least one of
an optical device corresponding to the photoelectric conversion device,
a control device configured to control the photoelectric conversion device,
a processing device configured to process a signal output from the photoelectric conversion device,
a mechanical device that is controlled based on information obtained by the photoelectric conversion device,
a display device configured to display information obtained by the photoelectric conversion device, and
a storage device configured to store information obtained by the photoelectric conversion device.
